# EUROPEAN PATENT SPECIFICATION

(11) **EP 3 800 651 B1**
(45) Date of publication and mention of the grant of the patent: **13.09.2023**
(21) Application number: 20199446.4
(22) Date of filing: 30.09.2020
(51) Int. Cl.: H01F 17/00, H05K 1/16, H01F 41/04

(54) **WIRING SUBSTRATE HAVING INDUCTOR FUNCTION AND METHOD FOR PRODUCING THE SAME**
VERDRAHTUNGSSUBSTRAT MIT INDUKTIONSFUNKTION UND VERFAHREN ZUR HERSTELLUNG DAVON
SUBSTRAT DE CÂBLAGE AYANT UNE FONCTION D'INDUCTEUR ET SON PROCÉDÉ DE PRODUCTION

(30) Priority: 02.10.2019 JP 2019182431
(43) Date of publication of application: 07.04.2021
(73) Proprietor: AJINOMOTO CO., INC., Chuo-ku Tokyo 104-8315 (JP)
(72) Inventor: OOYAMA, Hideki, Kawasaki-shi, Kanagawa 210-0801 (JP); TANAKA, Takayuki, Kawasaki-shi, Kanagawa 210-0801 (JP); HAGIWARA, Chihiro, Kawasaki-shi, Kanagawa 210-0801 (JP)
(74) Representative: Mewburn Ellis LLP

(56) References cited:
- US-A1- 2015 348 695
- US-A1- 2019 274 217

## Description

### BACKGROUND OF THE INVENTION

### 1. Field of the Invention

The present invention relates to a wiring substrate having an inductor function and a method for producing the same. In particular, the present invention relates to a wiring substrate with built-in inductor structure and a method for producing the same.

### 2. Description of the Related Art

Various kinds of inductors are incorporated in high-performance electronic devices such as a cellular phone, a smartphone, and a tablet PC. As an inductor component that is mounted on or embedded in a wiring substrate, there can be used, for example, inductor components described in Patent Documents 1 and 2.

In recent years, electronic devices have become downsized, and a wiring substrate used in such electronic devices is required to become more functionalized and downsized. As for an inductor, a technique for building inductor structure into a wiring substrate is expected instead of/in addition to a technique for using an independent inductor component.

As the technique for building inductor structure into a wiring substrate, there can be considered, for example, a method of using a magnetic sheet as an internal layer substrate and forming a solenoid-shaped conductor pattern in the magnetic sheet to form an inductor structure, based on a method for producing the inductor component in Patent Document 2. There can be also considered a method of storing a magnetic material in a part of region of an insulating substrate and forming a solenoid-shaped conductor pattern by, for example, providing a through hole conductor in the insulating substrate around the magnetic material to form an inductor structure, as proposed in Patent Document 3.
US 2019/274217 A1 discloses inductors with embedded magnetic cores and methods of making such inductors.
US 2015/348695 A1 discloses a method of producing a coil integrated in a substrate, using the following steps: creating the cavity in a substrate, said cavity having an open end which interrupts a surface of the substrate, introducing a paste containing ferromagnetic particles into the cavity so as to produce a coil core, closing the cavity by applying a cover layer so as to bridge the interruption in the surface of the substrate, introducing first winding portions of the coil which are vertical with respect to the surface, with a plurality or all of the first winding portions passing through the coil core contained inside the cavity, and applying second winding portions of the coil onto the surfaces of the substrate, with the second winding portions contacting the first winding portions so as to create the windings of the coil.

### Related Art Document

### Patent Document

Patent Document 1: JP-A-2016-197624
Patent Document 2: JP-A-2014-116465
Patent Document 3: JP-A-2016-39256

### SUMMARY OF THE INVENTION

### Problem to be Solved by the Invention

However, in the method of using a magnetic sheet as an internal layer substrate and forming a solenoid-shaped conductor pattern in the magnetic sheet, insulating properties in planar direction (a main surface direction of the substrate) are low, and desired inductance characteristics are unlikely to be achieved.

Also in the method of storing a magnetic material in a part of region of an insulating substrate and forming a solenoid-shaped conductor pattern by, for example, providing a through hole conductor in the insulating substrate around the magnetic material, the magnetic material is present inside the solenoid-shaped conductor pattern (conductor coil), but the magnetic material is not present outside the conductor coil. Therefore, desired inductance characteristics are unlikely to be achieved.

The present invention provides a wiring substrate with built-in inductor structure having excellent insulating properties in planar direction and having excellent inductance characteristics by the presence of magnetic material not only inside an inductor coil but also outside the inductor coil, and a method for producing the same.

### Means for Solving Problem

The present invention includes the following embodiments.

A wiring substrate having an inductor function, the wiring substrate comprising:
an internal layer substrate that has first and second main surfaces and an opening formed to penetrate the first and the second main surfaces;
a magnetic material layer that is provided inside the opening and has a first through hole formed to penetrate first and second main surfaces of the magnetic material layer;
an insulator that is provided inside the first through hole and has a second through hole formed to penetrate the insulator; and
an inductor including a first conductor pattern provided directly on the first main surface of the magnetic material layer, a second conductor pattern provided directly on the second main surface of the magnetic material layer, and a through hole conductor provided inside the second through hole and connecting the first conductor pattern to the second conductor pattern as set out in claim 1.

A method for producing a wiring substrate having an inductor function as defined in claim 8.

Other advantageous features are set out in the dependent claims.

### Effect of Invention

The present invention can provide a wiring substrate with built-in inductor structure having excellent insulating properties in planar direction and having excellent inductance characteristics by the presence of magnetic material not only inside an inductor coil but also outside the inductor coil, and a method for producing the same.

### BRIEF DESCRIPTION OF THE DRAWINGS

Fig. 1 is a schematic plan view illustrating an inductor structure of a wiring substrate in an embodiment of the present invention.
Fig. 2 is a schematic view (1) for description of a production method in an embodiment of the present invention.
Fig. 3 is a schematic view (2) for description of the production method in the embodiment of the present invention.
Fig. 4 is a schematic view (3) for description of the production method in the embodiment of the present invention.
Fig. 5 is a schematic view (4) for description of the production method in the embodiment of the present invention.
Fig. 6 is a schematic view (5) for description of the production method in the embodiment of the present invention.
Fig. 7 is a schematic view (6) for description of the production method in the embodiment of the present invention.
Fig. 8 is a schematic view (7) for description of the production method in the embodiment of the present invention. Fig. 8 is also a schematic cross-sectional view of a wiring substrate 100 according to an embodiment of the present invention.
Fig. 9 is a schematic view (8) for description of the production method.
Fig. 10 is a schematic view (9) for description of the production method .
Fig. 11 is a schematic view (10) for description of the production method .
Fig. 12 is a schematic view (11) for description of the production method in a reference embodiment.

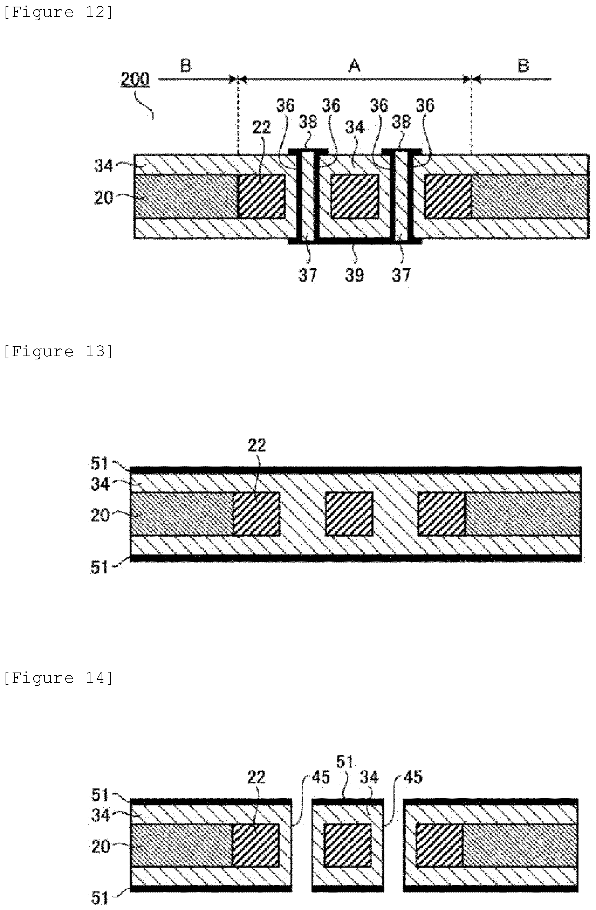

Fig. 12 is also a schematic cross-sectional view of a wiring substrate 200 according to a reference embodiment.
Fig. 13 is a schematic view (12) for description of the production method in the embodiment of the present invention.
Fig. 14 is a schematic view (13) for description of the production method .

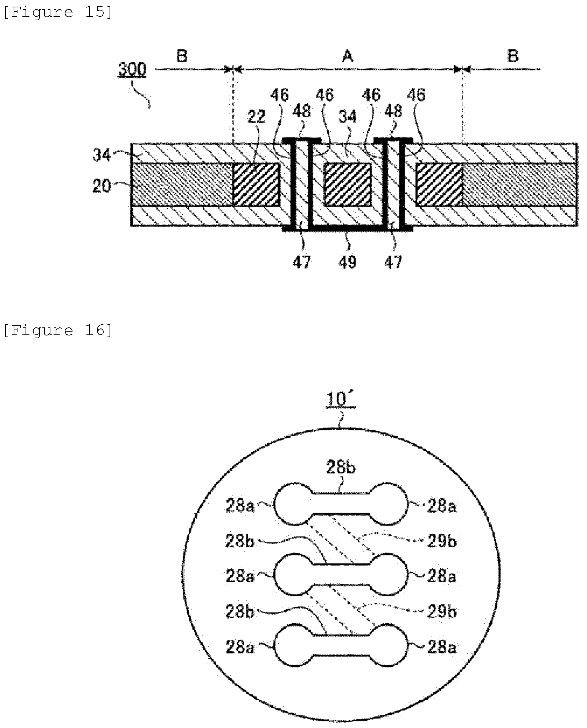

Fig. 15 is a schematic view (14) for description of the production method in a reference embodiment.
Fig. 15 is also a schematic cross-sectional view of a wiring substrate 300 according to a reference embodiment.
Fig. 16 is a schematic plan view illustrating an inductor structure of a wiring substrate in an embodiment of the present invention.

### DETAILED DESCRIPTION OF THE INVENTION

Hereinafter, embodiments of the present invention will be described with reference to the drawings. The drawings only schematically illustrate shapes, sizes, and arrangements of constituent elements enough to understand the present invention. The present invention is not limited by the following description, and each constituent element can be appropriately changed without departing from the scope of the present invention. In the drawings used for the following description, the same constituent elements are designated by the same reference numerals, and duplicated description may be omitted. Configurations according to the embodiments of the present invention are not necessarily limited to arrangements illustrated in the drawings during production or use.

### [Wiring Substrate having Inductor Function]

A wiring substrate of the present invention has a built-in inductor structure, and has an inductor function.

In the wiring substrate of the present invention, the inductor structure is characterized by including, as a portion of a solenoid-shaped conductor pattern (conductor coil), a through hole conductor provided inside a through hole that penetrates an insulator. In the wiring substrate of the present invention, a magnetic material layer is provided around the insulator in a main surface direction of the substrate (i.e., a direction parallel to a main surface of the substrate). Therefore, a magnetic material is also present outside the conductor coil. In the wiring substrate of the present invention, an internal layer substrate is provided so as to surround the magnetic material layer in the main surface direction of the substrate. Therefore, the magnetic material layer is disposed at a divided region in the main surface direction of the substrate. The conductor pattern that forms the conductor coil in combination with the through hole conductor is provided inside a region of the magnetic material layer as viewed in a direction perpendicular to the main surface of the substrate. Therefore, the whole conductor coil is disposed inside the region of the magnetic material layer as viewed in the direction perpendicular to the main surface of the substrate. The magnetic material layer is disposed at the divided region in the main surface direction of the substrate, and therefore the wiring substrate of the present invention has excellent insulating properties in planar direction. The conductor coil is provided inside the region of the magnetic material layer as viewed in the direction perpendicular to the main surface of the substrate. Thus, in the wiring substrate of the present invention, the magnetic material is present not only inside the conductor coil but also outside the conductor coil. The wiring substrate of the present invention exhibits excellent inductance characteristics. In the present invention, the "inside of the conductor coil" in terms of a positional relation between the solenoid-shaped conductor pattern (conductor coil) and the magnetic material means the inside of a cylindrical structure defined by the conductor coil. The "outside of the conductor coil" means the outside of the cylindrical structure defined by the conductor coil.

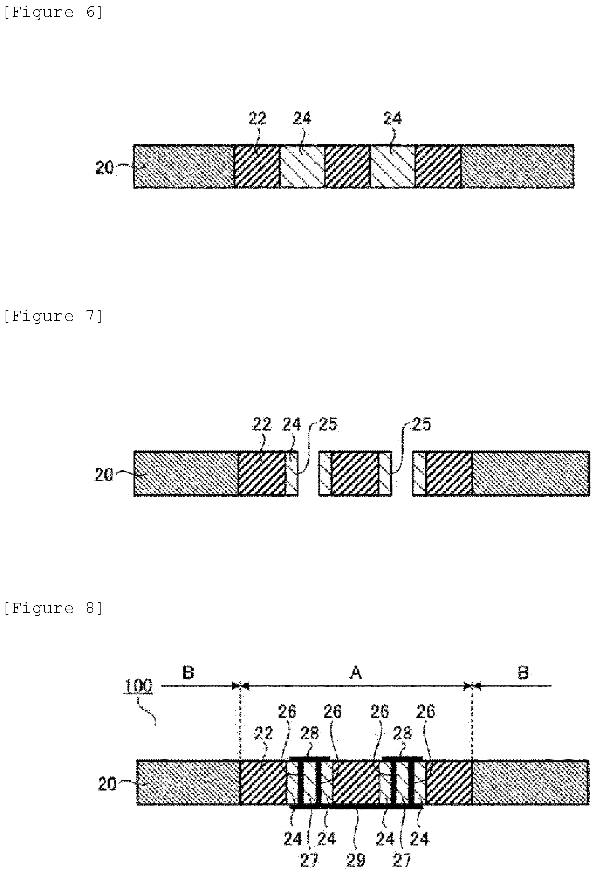

Structural features of the wiring substrate of the present invention will be described with reference to Figs. 8 (Figs. 12 and 15) and 1. It should be noted that details of constituent elements illustrated in Figs. 8 (Figs. 12 and 15) and 1 will be described later, and the structural features that should be especially noticed are described in this section. Fig. 8 is a schematic cross-sectional view of a wiring substrate 100 according to an embodiment of the present invention. The wiring substrate 100 illustrated in Fig. 8 includes an internal layer substrate 20 having an opening, a magnetic material layer 22 that is provided inside the opening and has a first through hole, an insulator 24 that is provided inside the first through hole and has a second through hole, and a through hole conductor 26 that is provided inside the second through hole. The wiring substrate 100 is characterized by including, as a portion of a conductor coil, the through hole conductor 26 that is provided inside the second through hole penetrating the insulator 24. The wiring substrate 100 has a magnetic material layer at a divided region (a region A in Fig. 8; that is divided from a region B of the internal layer substrate). Figs. 12 and 15 are schematic cross-sectional views of wiring substrates 200 and 300, respectively, according to reference embodiments , in which an insulating layer 34 is provided in contact with both main surfaces of the internal layer substrate 20. Like the wiring substrate 100 illustrated in Fig. 8, the wiring substrates 200 and 300 include a through hole conductor 36, 46 that is provided inside the second through hole penetrating the insulator as a portion of a conductor coil and have the magnetic material layer at a divided region in the main surface direction of the substrate (a region A in Figs. 12 and 15; that is divided from a region B of the internal layer substrate).

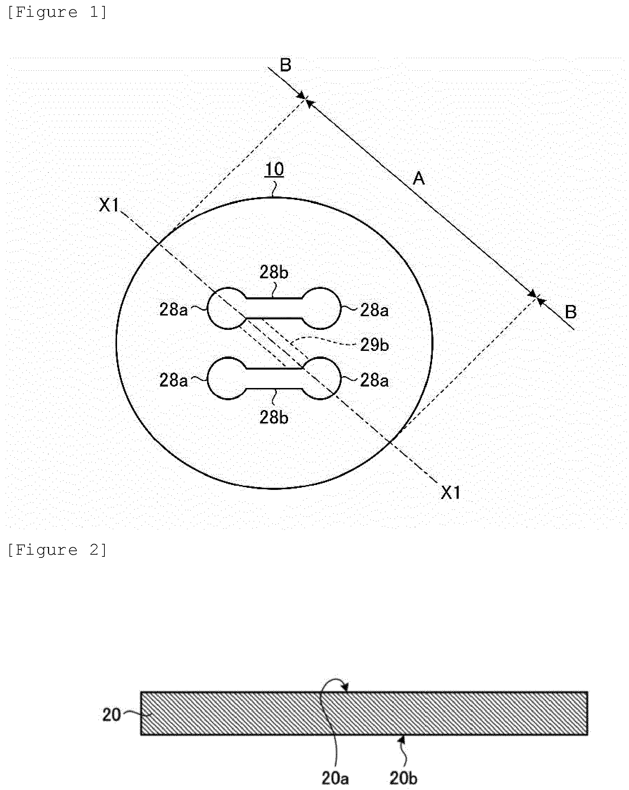

Fig. 1 is a schematic plan view illustrating an inductor structure 10 of a wiring substrate according to an embodiment of the present invention, specifically, the built-in inductor structure 10 in the wiring substrate. Symbols A and B in Fig. 1 correspond to the regions A and B, respectively, in Fig. 8 (Figs. 12 and 15). A cross section of the wiring substrate taken along a dash-dot-dash line X1-X1 in Fig. 1 corresponds to the schematic cross-sectional view of Fig. 8 (Figs. 12 and 15). The inductor structure 10 illustrated in Fig. 1 includes, inside the region A of the magnetic material layer, a solenoid-shaped conductor pattern (conductor coil) that includes a first conductor pattern (in Figs. 8, 12, and 15, "28," "38," and "48," respectively) including a through hole land 28a and a connection pattern 28b, a second conductor pattern (in Figs. 8, 12, and 15, "29," "39," and "49," respectively) including a through hole land 29a (not illustrated in Fig. 1) and a connection pattern 29b, and a through hole conductor (not illustrated in Fig. 1; in Figs. 8, 12, and 15, "26," "36," and "46," respectively). As described above, the through hole conductor is provided inside the second through hole penetrating the insulator. As seen from Fig. 1, the magnetic material is present not only inside the conductor coil but also outside the conductor coil in the inductor structure 10. A coil axis of the conductor coil illustrated in Fig. 1 extends in a vertical direction of Fig. 1. It should be noted that the magnetic material is present at an outside region in an axial direction of a cylindrical structure defined by the conductor coil and at an outside region in a side face direction of a cylindrical structure defined by the conductor coil.

In the present invention, the wiring substrate having the aforementioned structural features is achieved by a novel method which includes: forming an opening (first opening) in an internal layer substrate; providing a magnetic material layer inside the first opening; forming a through hole (second opening) in the magnetic material layer; providing an insulator inside the second opening; forming a through hole (third opening) in the insulator; and providing a through hole conductor inside the third opening to form a desired conductor coil.

In an embodiment, the wiring substrate of the present invention includes an internal layer substrate that has first and second main surfaces and an opening formed to penetrate the first and the second main surfaces, a magnetic material layer that is provided inside the opening and has a first through hole formed to penetrate first and second main surfaces of the magnetic material layer, an insulator that is provided inside the first through hole and has a second through hole formed to penetrate the insulator, and an inductor including a first conductor pattern formed on the first main surface of the magnetic material layer, a second conductor pattern formed on the second main surface of the magnetic material layer, and a through hole conductor that provided inside the second through hole and connecting the first conductor pattern to the second conductor pattern.

Hereinafter, the embodiments of the wiring substrate of the present invention will be described as appropriate with reference to the drawings including Figs. 8, 12, and 15. Details of each constituent element constituting the wiring substrate will be more obviously understood by considering description of Method for Producing Wiring Substrate having Inductor Structure described below.

In the following description, the first main surface of the internal layer substrate or the magnetic material layer conveniently represents an upper main surface of the internal layer substrate or the magnetic material layer as illustrated in the drawings, and the second main surface of the internal layer substrate or the magnetic material layer conveniently represents a lower main surface of the internal layer substrate or the magnetic material layer as illustrated in the drawings. The "first (second) main surface of the magnetic material layer" means a main surface at a region of the magnetic material layer (the region A in Figs. 1 and 8, etc.), and the "first (second) main surface of the internal layer substrate" means a main surface at a region of the internal layer substrate (the region B in Figs. 1 and 8, etc.).

### Internal layer substrate

In the wiring substrate of the present invention, a known internal layer substrate that can be used in production of a wiring substrate may be used as the internal layer substrate. The internal layer substrate may be an insulating substrate or a circuit substrate.

An insulating substrate refers to a sheet-shaped substrate that has first and second main surfaces opposed to each other and exhibits electric insulation properties. Examples of the insulating substrate include a glass epoxy substrate, a polyester substrate, a polyimide substrate, a BT resin substrate, a thermosetting polyphenylene ether substrate, a glass substrate, and a ceramic substrate. As the insulating substrate, a cured prepreg may be used. The cured prepreg refers to a cured product of a prepreg. A prepreg is a sheet-shaped material containing a thermosetting resin composition and a sheet-shaped fibrous substrate. For example, the prepreg can be formed by impregnating the thermosetting resin composition in the sheet-shaped fibrous substrate.

A circuit substrate refers to a sheet-shaped substrate that has first and second main surfaces opposed to each other and has patterned circuit wiring (interlayer wiring such as via wiring or through hole wiring, surface wiring, and the like; not illustrated in the drawings of the specification) on one or both of the first and the second main surfaces. The "circuit substrate" in the present invention also includes an internal layer circuit substrate that is an intermediate product on which an insulating layer and/or a conductive layer is further to be formed in production of a wiring substrate. A substrate (base substrate) used for the circuit substrate may be the aforementioned insulating substrate.

The thickness of the internal layer substrate is not particularly limited, and may be determined according to design details of a wiring substrate to be produced. In view of thinning the wiring substrate, the thickness of the internal layer substrate is preferably 2 mm or less, more preferably 1.5 mm or less, and further preferably 1.2 mm or less, 1.0 mm or less, or 0.8 mm or less. The lower limit of the thickness of the internal layer substrate is not particularly limited and is preferably 50 µm or more, and more preferably 60 µm or more, 80 µm or more, or 100 µm or more. When the circuit substrate is used as the internal layer substrate, it is suitable that the thickness of a base substrate of the circuit substrate fall within the aforementioned range.

When using the circuit substrate as the internal layer substrate, the size of a circuit wiring in the circuit substrate may be determined according to design details of the wiring substrate to be produced. In view of thinning the wiring substrate, the thickness of a surface wiring is preferably 40 µm or less, and more preferably 35 µm or less, 30 µm or less, or 25 µm or less. The lower limit of the thickness of the surface wiring is not particularly limited, and is generally 1 µm or more, 3 µm or more, or 5 µm or more.

In the internal layer substrate, the opening (first opening) that penetrates the first and the second main surfaces thereof is formed (in Figs. 8, 12, and 15, the region A corresponds to the opening of the internal layer substrate 20). The shape of the opening is not particularly limited and may be any shape such as a rectangular shape, a circular shape, a substantially rectangular shape, or a substantially circular shape. The size of the opening depends on a design of the inductor structure. For example, when the shape of the opening is a rectangular shape, the size thereof is preferably 5 mm × 5 mm or less, and more preferably 3 mm × 3 mm or less, or 2 mm × 2 mm or less. When the shape of the opening is a circular shape, the diameter thereof is preferably 5 mm or less, and more preferably 3 mm or less, or 2 mm or less. The lower limit of the size of the opening depends on the size of a built-in inductor structure to be formed. When the shape of the opening is a rectangular shape, the size thereof may be generally 0.5 mm × 0.5 mm or more. When the shape of the opening is a circular shape, the diameter thereof may be generally 0.5 mm or more. When the circuit substrate is used as the internal layer substrate, the opening is formed at a region where the circuit wiring is not formed in the circuit substrate.

Figs. 8, 12, and 15 illustrate the internal layer substrate 20 having only one opening. However, a plurality of openings may be formed at predetermined intervals therebetween. When the internal layer substrate has a plurality of openings, the shape and size of openings may be the same as or different from each other.

### Magnetic Material Layer

The wiring substrate of the present invention includes the magnetic material layer 22 that is provided inside the opening of the internal layer substrate 20.

The magnetic material layer 22 is provided inside the opening of the internal layer substrate 20 so that first and second main surfaces of the magnetic material layer substantially correspond to the first and the second main surfaces of the internal layer substrate 20, respectively, in the direction perpendicular to the main surface of the substrate (in a thickness direction of the substrate). That is, the magnetic material layer is neither protruded from nor dented from the internal layer substrate, and is provided so as to have substantially the same thickness as that of the internal layer substrate. Inside the opening of the internal layer substrate 20, the magnetic material layer 22 is provided in contact with the internal layer substrate 20.

A composition of the magnetic material layer 22 is not particularly limited as long as the magnetic material layer 22 is a layer formed from a magnetic material. For example, the magnetic material layer may be a cured product layer obtained by curing a magnetic material composition (also referred to as "magnetic material paste") containing a magnetic material powder and a binder resin. Details of the magnetic material paste will be described in "Method for Producing Wiring Substrate having Inductor Function" described below.

The magnetic material layer 22 includes the first through hole penetrating the first and the second main surfaces thereof. The first through hole is also referred to as the "second opening" in relation to the opening (first opening) of the internal layer substrate 20.

In order to achieve a desired conductor coil, a plurality of the first through holes are formed in the magnetic material layer 22. For example, when the winding number N of the conductor coil is 1, four through holes may be provided as illustrated in Fig. 1. When the winding number N of the conductor coil is 2, six through holes may be provided as illustrated in Fig. 16. The number of the first through holes may be determined as appropriate according to a desired design of the conductor coil. It should be noted that the schematic cross-sectional views illustrated in Figs. 8, 12, and 15 correspond to the cross section of the wiring substrate taken along the dash-dot-dash line X1-X1 in Fig. 1 and only two first through holes are illustrated.

The shape of the first through holes is not particularly limited and may be any shape such as a rectangular shape, a circular shape, a substantially rectangular shape, or a substantially circular shape. The size of the first through holes (second openings) and the pitch therebetween are not particularly limited as long as they can achieve the desired design of conductor coil in relation to the size of the first opening.

In view of achieving a wiring substrate having more excellent inductance characteristics, in consideration of the cylindrical structure defined by the solenoid-shaped conductor pattern (conductor coil), it is preferable that the positions of first through holes be determined so that a sufficient magnetic material is present at the outside region in the axial direction of the cylindrical structure as well as the outside region in the side face direction of the cylindrical structure. For example, when the diameter of the first through holes is defined as D1, distance from the center of the first through hole to the internal layer substrate in the cylindrical axial direction (in Figs. 1 and 16, the vertical direction of the drawing sheets) of the conductor coil are preferably 0.7D1 or more, and more preferably 0.8D1 or more, 0.9D1 or more, or D1 or more. Distance from the center of the first through hole to the internal layer substrate in the cylindrical side face direction (a direction perpendicular to the cylindrical axial direction of the conductor coil; in Figs. 1 and 16, a horizontal direction of the drawing sheets) of the conductor coil are preferably 0.7D1 or more, and more preferably 0.8D1 or more, 0.9D1 or more, or D1 or more.

### Insulator

The wiring substrate of the present invention includes the insulator 24 that is provided inside the first through hole of the magnetic material layer 22.

It is preferable that the insulator 24 be provided inside the first through holes of the magnetic material layer 22 so that first and second main surfaces of the insulator substantially correspond to the first and the second main surfaces of the magnetic material layer 22 (and the internal layer substrate 20), respectively, in the direction perpendicular to the main surface of the substrate (in the thickness direction of the substrate). That is, it is preferable that the insulator be neither protruded from nor dented from the magnetic material layer, and be provided so as to have substantially the same thickness as that of the magnetic material layer. Inside the first through holes of the magnetic material layer, the insulator 24 is provided in contact with the magnetic material layer 22. In illustration of the wiring substrates according to the embodiments in Figs. 12 and 15 in which the insulating layer 34 is provided in contact with both the main surfaces of the internal layer substrate 20, an insulating member derived from the insulator 24 which is provided inside the first through holes of the magnetic material layer 22 is not distinguished from the insulating layer 34. However, the composition of the insulator 24 may be the same as or different from that of the insulating layer 34.

The composition of the insulator 24 is not particularly limited as long as the insulator 24 has electrical insulating properties. For example, the insulator may be a cured product layer obtained by curing a resin composition (also referred to as "insulating hole-embedding paste") containing an insulating resin. Details of the insulating hole-embedding paste will be described in "Method for Producing Wiring Substrate having Inductor Function" described below.

The second through hole is formed in the insulator 24 that is provided inside the first through hole of the magnetic material layer 22. Therefore, the number of the second through holes may be usually the same as the number of the first through holes. For example, when the winding number N of the conductor coil is 1, four first through holes are provided as illustrated in Fig. 1, and the insulator may be provided inside each of the first through holes, and then the second through hole may be formed in each of them. When the winding number N of the conductor coil is 2, six first through holes are provided as illustrated in Fig. 16, and the insulator may be provided inside each of the first through holes, and then the second through hole may be formed in each of them. It should be noted that the schematic cross-sectional views illustrated in Figs. 8, 12, and 15 correspond to the cross section of the wiring substrate taken along the dash-dot-dash line X1-X1 in Fig. 1 and only two second through holes are illustrated.

The shape of the second through holes is not particularly limited and may be any shape such as a rectangular shape, a circular shape, a substantially rectangular shape, or a substantially circular shape. The size of the second through holes and the pitch therebetween are not particularly limited as long as they can achieve the desired design of conductor coil in relation to the size of the first opening. For example, when the diameter of the first through holes is defined as D1, a diameter D2 of the second through holes is preferably 0.8D1 or less, and more preferably 0.7D1 or less, 0.6D1 or less, or 0.5D1 or less, and preferably 0.2D1 or more, and more preferably 0.3D1 or more. When the diameter D2 of the second through holes falls within such a range, the insulator around the through hole conductor has sufficient thickness, and a wiring substrate having more excellent inductance characteristics can be achieved. It is suitable that the positions of the second through holes be determined so that the pitch of the second through holes is substantially the same as the pitch of the first through holes.

In the present invention, the wiring substrate having the aforementioned structural features is achieved by forming the first through holes in the magnetic material layer, providing the insulator inside each of the first through holes, forming the second through holes in the insulators, and providing through hole conductors inside the second through holes to form a desired conductor coil.

### Inductor

The wiring substrate of the present invention includes an inductor including the first conductor pattern 28, 38, or 48 formed on the first main surface of the magnetic material layer 22, the second conductor pattern 29, 39, or 49 formed on the second main surface of the magnetic material layer 22, and the through hole conductor 26, 36, or 46 provided inside the second through holes and connecting the first conductor pattern to the second conductor pattern.

In the present invention, the first conductor pattern "formed on the first main surface of the magnetic material layer" includes the first conductor pattern that is provided directly in contact with the first main surface of the magnetic material layer. Similarly, the second conductor pattern "formed on the second main surface of the magnetic material layer" includes the second conductor pattern that is provided directly in contact with the second main surface of the magnetic material layer. Reference embodiments include first and/or second conductor patterns provided through the other layer on the respective main surface of the magnetic material layer. Herein, the other layer is not particularly limited as long as it does not inhibit the effects. Examples thereof include an insulating layer. In an embodiment, the wiring substrate further includes the insulating layer 34 that is provided in contact with the first main surface of the internal layer substrate 20 and the first main surface of the magnetic material layer 22. In this embodiment, the first conductor pattern 38 or 48 is provided in contact with a surface of the insulating layer 34 on the first main surface of the magnetic material layer 22. In another embodiment, the wiring substrate further includes the insulating layer 34 that is provided in contact with the second main surface of the internal layer substrate 20 and the second main surface of the magnetic material layer 22. In this embodiment, the second conductor pattern 39 or 49 is provided in contact with a surface of the insulating layer 34 on the second main surface of the magnetic material layer 22.

In the wiring substrate 100 illustrated in Fig. 8, the first conductor pattern 28 and the second conductor pattern 29 are provided in contact with the first main surface and the second main surface of the magnetic material layer 22, respectively. In the wiring substrates 200 and 300 illustrated in Figs. 12 and 15, the first conductor patterns 38 and 48 are provided in contact with the surface of the insulating layer 34 on the first main surface of the magnetic material layer 22, and the second conductor patterns 39 and 49 are provided in contact with the surface of the insulating layer 34 on the second main surface of the magnetic material layer 22.

The first and the second conductor patterns are connected by the through hole conductor provided inside the second through holes of the insulators to form the solenoid-shaped conductor pattern (conductor coil). As a result, an inductor function is expressed.

The structure of the first conductor pattern is not limited as long as the first conductor pattern can form the conductor coil in combination with the through hole conductor and the second conductor pattern. For example, the first conductor pattern may include the through hole land 28a and the connection pattern 28b that connects the through hole land to another through hole land (Fig. 1). Similarly, the second conductor pattern may include the through hole land 29a and the connection pattern 29b that connects the through hole land to another through hole land (Fig. 1; the through hole land 29a is not illustrated).

The structure of the through hole conductor is not limited as long as the through hole conductor can form the conductor coil in combination with the first and the second conductor patterns. For example, the through hole conductor may be a hollow cylindrical conductor (conformalthrough hole conductor) in which a through hole wall is plated, or a columnar conductor (filled through hole conductor) in which the through hole is filled with a conductor. When the through hole conductor is a conformal-through hole conductor, the inside of the hollow cylindrical conductor may be filled with an insulator 27, 37, or 47.

### Other Structures

When the wiring substrate includes the insulating layer 34 that is provided in contact with at least one of the first and the second main surfaces of the internal layer substrate 20 (Figs. 12 and 15), the wiring substrate may include a conductor layer (wiring layer; not illustrated in the drawings) that is provided in contact with the surface of the insulating layer.

In the wiring substrate of the present invention, the insulating layer and the conductor layer (wiring layer) may be alternately provided on at least one of the first and the second main surfaces of the internal layer substrate 20 (and the magnetic material layer 22) to form a multi-layer wiring. As for design details of the insulating layer, the wiring layer, and the multi-layer wiring, any layer constitution and design known in production of the wiring substrate may be used. For example, when using the wiring substrates illustrated in Figs. 8, 12, and 15 as an internal layer circuit substrate, and alternately providing the insulating layer and the conductor layer on the internal layer circuit substrate, there can be produced a wiring substrate with built-in inductor structure and including a multi-layer wiring.

Semiconductor devices of various aspects can be produced using the wiring substrate of the present invention. A semiconductor device including such a wiring substrate can be suitably used in, for example, an electrical product (e.g., a computer, a cellular phone, a digital camera, and television), and a vehicle (e.g., a motorcycle, an automobile, a train, a ship, and an airplane).

### [Method for Producing Wiring Substrate having Inductor Function]

The present invention also provides a novel method for producing the wiring substrate having an inductor function.

The method of the present invention includes: preparing the internal layer substrate having an opening; providing the magnetic material layer inside the opening; providing the first through hole in the magnetic material layer; providing the insulator inside the first through hole; providing the second through hole in the insulator; and providing the conductor patterns on both the main surfaces of the magnetic material layer and connecting the conductor patterns to the through hole conductor inside the second through hole to form the solenoid-shaped conductor pattern. Thus, there can be achieved the wiring substrate having the aforementioned structural features, specifically, the wiring substrate that has the magnetic material layer at the divided area in the main surface direction of the substrate and has the solenoid-shaped conductor pattern (conductor coil) inside the region of the magnetic material layer as viewed in the direction perpendicular to the main surface direction of the substrate.

Hereinafter, an embodiment of the method for producing the wiring substrates illustrated in Figs. 8, 12, and 15 will be described in detail with reference to the drawings.

In an embodiment, the method for producing the wiring substrate having an inductor function of the present invention includes the following steps (A) to (G):
(A) preparing the internal layer substrate that has the first and the second main surfaces and the opening formed to penetrate the first and the second main surfaces;
(B) filling the inside of the opening with a magnetic material paste and thermally curing the magnetic material paste to provide the magnetic material layer;
(C) forming the first through hole to penetrate the first and the second main surfaces of the magnetic material layer;
(D) providing the insulator inside the first through hole;
(E) forming the second through hole to penetrate the insulator;
(F) forming the through hole conductor inside the second through hole; and
(G) forming the first and the second conductor patterns on the first and the second main surfaces of the magnetic material layer, respectively, to connect the first and the second conductor patterns to the through hole conductor in a solenoid shape.

### Step (A)

In the step (A), the internal layer substrate that has the first and the second main surfaces and the opening that is formed to penetrate the first and the second main surfaces is prepared.

Firstly, the internal layer substrate is prepared (Fig. 2). The internal layer substrate 20 has a first main surface 20a and a second main surface 20b. A known internal layer substrate that can be used in production of a wiring substrate may be used as the internal layer substrate 20. The internal layer substrate may be an insulating substrate or a circuit substrate. Details of the internal layer substrate 20 are as described above. It should be noted that when the internal layer substrate 20 is a circuit substrate, patterned circuit wiring (interlayer wiring such as via wiring or through hole wiring, surface wiring, and the like), not illustrated in the drawings, is provided on one or both of the first and the second main surfaces.

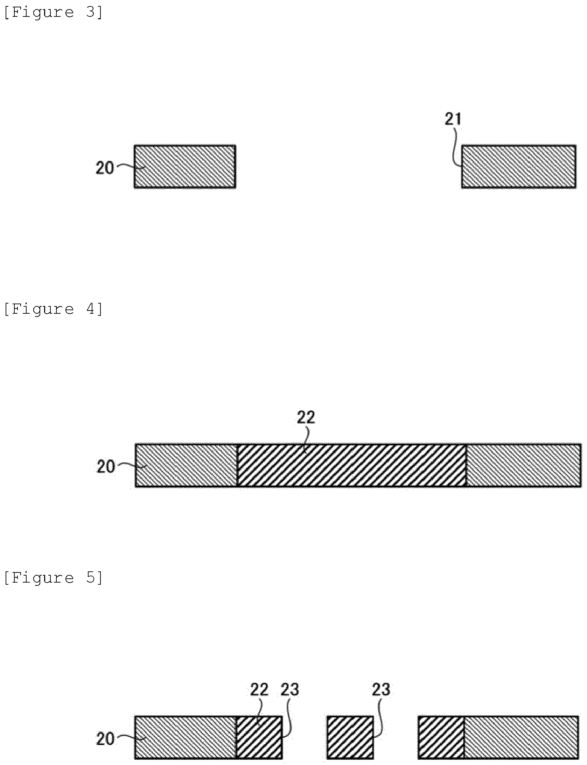

Subsequently, an opening penetrating the first and the second main surfaces is formed in the internal layer substrate (Fig. 3). As schematically illustrated in Fig. 3, an opening 21 penetrating the first and the second main surfaces of the internal layer substrate can be formed at a predetermined position of the internal layer substrate 20. When the internal layer substrate 20 is a circuit substrate, the opening 21 may be formed at a region of a base substrate where no circuit wiring is formed. In consideration of characteristics of the internal layer substrate 20 and the size of the opening 21, the opening 21 can be formed by, for example, a known method using a drill, a laser, plasma, or an etching medium. The shape and size of the opening 21 are as described above.

Although Fig. 3 illustrates only one opening 21, a plurality of openings 21 may be provided at predetermined intervals. When providing a plurality of openings 21, it is able to build a plurality of inductor structures into the wiring substrate.

### Step (B)

In the step (B), a magnetic material paste is filled into the inside of the opening, and the magnetic material paste is thermally cured to provide the magnetic material layer.

The magnetic material paste contains (a) a magnetic powder and (b) a binder resin. The magnetic material may further contain (c) a dispersant, (d) a curing accelerator, and (e) other additive, if necessary.

### (a) Magnetic Powder

Examples of the magnetic powder include a pure iron powder; iron oxide powders such as Mg-Zn-based ferrite, Fe-Mn-based ferrite, Mn-Zn-based ferrite, Mn-Mg-based ferrite, Cu-Zn-based ferrite, Mg-Mn-Sr-based ferrite, Ni-Zn-based ferrite, Ba-Zn-based ferrite, Ba-Mg-based ferrite, Ba-Ni-based ferrite, Ba-Co-based ferrite, Ba-Ni-Co-based ferrite, Y-based ferrite, an iron (III) oxide powder, and triiron tetraoxide; iron alloy-based metal powders such as a Fe-Si-based alloy powder, a Fe-Si-Al-based alloy powder, a Fe-Cr-based alloy powder, a Fe-Cr-Si-based alloy powder, a Fe-Ni-Cr-based alloy powder, a Fe-Cr-Al-based alloy powder, a Fe-Ni-based alloy powder, a Fe-Ni-Mo-based alloy powder, a Fe-Ni-Mo-Cu-based alloy powder, a Fe-Co-based alloy powder, and a Fe-Ni-Co-based alloy powder; and amorphous alloys such as Co-based amorphous alloy.

In particular, the magnetic powder is preferably at least one kind selected from iron oxide powders and iron alloy-based metal powders. It is preferable that the iron oxide powder contain a ferrite containing at least one kind selected from Ni, Cu, Mn, and Zn. It is preferable that the iron alloy-based metal powder contain an iron alloy-based metal powder containing at least one kind selected from Si, Cr, Al, Ni, and Co.

As the magnetic powder, a commercially available magnetic powder can be used. Specific examples of the commercially available magnetic powder include "M05S" available from Powdertech Co., Ltd.; "PST-S" available from Sanyo Special Steel Co., Ltd.; "AW2-08," "AW2-08PF20F," "AW2-08PF10F," "AW2-08PF3F," "Fe-3.5Si-4.5CrPF20F," "Fe-50NiPF20F," and "Fe-80Ni-4MoPF20F" available from EPSON ATMIX Corporation; "LD-M," "LD-MH," "KNI-106," "KNI-106GSM," "KNI-106GS," "KNI-109," "KNI-109GSM," and "KNI-109GS" available from JFE Chemical Corporation; "KNS-415," "BSF-547," "BSF-029," "BSN-125," "BSN-125," "BSN-714," "BSN-828," "S-1281," "S-1641," "S-1651," "S-1470," "S-1511," and "S-2430" available from TODA KOGYO CORP.; "JR09P2" available from Japan Metals & Chemicals Co., Ltd.; "Nanotek" available from CIK NanoTek Corporation; "JEMK-S," and "JEMK-H" available from KINSEI MATEC CO., LTD.; and "Yttrium iron oxide" available from Sigma-Aldrich Co. LLC. The magnetic powder may be used alone or in combination of two or more kinds thereof.

It is preferable that the magnetic powder have a spherical shape. A value (aspect ratio) obtained by dividing the major axis length of the magnetic powder by the minor axis length thereof is preferably 2 or less, more preferably 1.5 or less, and further preferably 1.2 or less. In general, when the shape of the magnetic powder is flat, but not spherical, specific magnetic permeability is likely to be improved. However, it is particularly preferable that a spherical magnetic powder be used since magnetic loss can be decreased, and a paste having preferable viscosity is obtained.

In view of improving the specific magnetic permeability, the average particle diameter of the magnetic powder is preferably 0.01 µm or more, more preferably 0.5 µm or more, and further preferably 1 µm or more, and preferably 10 µm or less, more preferably 9 µm or less, and further preferably 8 µm or less.

The average particle diameter of the magnetic powder can be measured using laser diffraction and scattering method on the basis of the Mie scattering theory. Specifically, the particle size distribution of the magnetic powder is prepared on the volume basis using a laser diffraction and scattering particle size distribution measuring device, and the median diameter thereof can be measured as an average particle diameter. A measurement sample obtained by ultrasonically dispersing the magnetic powder in water can be preferably used. Examples of the laser diffraction and scattering particle size distribution measuring device include "LA-500" manufactured by Horiba, Ltd., "SALD-2200" manufactured by Shimadzu Corporation, or the like.

In view of improving the specific magnetic permeability, the specific surface area of the magnetic powder is preferably 0.05 m²/g or more, more preferably 0.1 m²/g or more, and further preferably 0.3 m²/g or more, and preferably 10 m²/g or less, more preferably 8 m²/g or less, and further preferably 5 m²/g or less. The specific surface area of the magnetic powder can be measured by a BET method.

In view of improving the specific magnetic permeability and decreasing a loss factor, the content (% by volume) of the magnetic powder is preferably 40% by volume or more, more preferably 50% by volume or more, and further preferably 60% by volume or more, when the volume of nonvolatile components in the magnetic material paste is defined as 100% by volume. The upper limit of the content (% by volume) is not particularly limited and may be preferably 95% by volume or less, or 90% by volume or less.

In view of improving the specific magnetic permeability and decreasing the loss factor, the content (% by mass) of the magnetic powder is preferably 70% by mass or more, more preferably 75% by mass or more, and further preferably 80% by mass or more, when the amount of nonvolatile components in the resin composition is defined as 100% by mass. The upper limit of the content (% by mass) is not particularly limited and may be preferably 99% by mass or less, or 98% by mass or less.

### (b) Binder Resin

The binder resin is not particularly limited as long as it is a resin capable of dispersing and bonding the magnetic material in the magnetic material paste to form the magnetic material layer.

Examples of the binder resin include thermosetting resins such as an epoxy resin, a phenolic resin, a naphthol-based resin, a benzoxazine-based resin, an active ester-based resin, a cyanate ester-based resin, a carbodiimide-based resin, an amine-based resin, and an acid anhydride-based resin; and thermoplastic resins such as a phenoxy resin, an acrylic resin, a polyvinyl acetal resin, a butyral resin, a polyimide resin, a polyamideimide resin, a polyether sulfone resin, and a polysulfone resin. As the binder resin, it is preferable to use a thermosetting resin which is used for formation of the insulating layer of the wiring substrate. Among these, an epoxy resin is preferable. The binder resin may be used alone or in combination of two or more kinds thereof.

Herein, a component that is reacted with an epoxy resin to cure the magnetic material paste, such as a phenolic resin, a naphthol-based resin, a benzoxazine-based resin, an active ester-based resin, a cyanate ester-based resin, a carbodiimide-based resin, an amine-based resin, or an acid anhydride-based resin, is also referred to as "curing agent."

The epoxy equivalent weight of the epoxy resin is preferably 50 g/eq. to 5,000 g/eq., more preferably 50 g/eq. to 3,000 g/eq., further preferably 80 g/eq. to 2,000 g/eq., and still more preferably 110 g/eq. to 1,000 g/eq. When the epoxy equivalent weight falls within such a range, the crosslink density of a cured product becomes sufficient, and a magnetic material layer having small surface roughness can be provided. The epoxy equivalent weight is the mass of a resin containing 1 equivalent of epoxy group and can be measured in accordance with JIS K7236.

The weight average molecular weight of the epoxy resin is preferably 100 to 5,000, more preferably 250 to 3,000, and further preferably 400 to 1,500. The weight average molecular weight of the epoxy resin is a polystyrene-equivalent weight average molecular weight measured by gel permeation chromatography (GPC).

When containing the epoxy resin and the curing agent as the binder resin, the quantitative ratio of the epoxy resin to the whole curing agent, in terms of a ratio of [the total number of epoxy groups in the epoxy resin]:[the total number of reactive groups in the curing agent], is preferably within a range of 1:0.01 to 1:5, more preferably 1:0.5 to 1:3, and further preferably 1:1 to 1:2. The "number of epoxy groups in the epoxy resin" is a value obtained by dividing the mass of nonvolatile components in each epoxy resin by respective epoxy equivalent weight and summing all the calculated values for all epoxy resin in the magnetic material paste. The "number of active groups in the curing agent" is a value obtained by dividing the mass of nonvolatile components in each curing agent by respective active group equivalent weight and summing all the calculated values for all curing agents in the magnetic material paste.

In view of dispersing and bonding the magnetic powder in the magnetic material paste to form the magnetic material layer, the content of the binder resin is preferably 1% by mass or more, 3% by mass or more, or 5% by mass or more, when the amount of nonvolatile components in the magnetic material paste is defined as 100% by mass. The upper limit of the content is not particularly limited as long as the effects of the present invention can be obtained, and is preferably 25% by mass or less, 20% by mass or less, or 15% by mass or less.

### (c) Dispersant

The magnetic material paste may further contain a dispersant. When using the dispersant, the dispersibility of the magnetic powder can be improved.

Examples of the dispersant may include phosphate-based dispersants such as polyoxyethylene alkyl ether phosphate; anionic dispersants such as sodium dodecyl benzenesulfonate, sodium lauryl, and an ammonium salt of polyoxyethylene alkyl ether sulfate; and nonionic dispersants such as an organosiloxane-based dispersant, acetylene glycol, a polyoxyethylene alkyl ether, a polyoxyethylene alkyl ester, a polyoxyethylene sorbitan fatty acid ester, a polyoxyethylene alkyl phenyl ether, a polyoxyethylene alkylamine, and a polyoxyethylene alkylamide. Among these, an anionic dispersant is preferable. The dispersant may be used alone or in combination of two or more kinds thereof.

The content of the dispersant is preferably 0.1% by mass or more, 0.2% by mass or more, or 0.4% by mass or more, when the amount of nonvolatile components in the magnetic material paste is defined as 100% by mass. The upper limit of the content is preferably 5% by mass or less, 3% by mass or less, or 1% by mass or less.

### (d) Curing Accelerator

The magnetic material paste may further contain a curing accelerator. When using the curing accelerator, it is able to effectively promote curing of the binder resin to enhance the mechanical strength of a cured product. Examples of the curing accelerator include an amine-based curing accelerator, an imidazole-based curing accelerator, a phosphorus-based curing accelerator, a guanidine-based curing accelerator, and a metallic curing accelerator. In view of obtaining a magnetic material paste having moderate viscosity, the curing accelerator is preferably an amine-based curing accelerator or an imidazole-based curing accelerator, and more preferably an imidazole-based curing accelerator. The curing accelerator may be used alone or in combination of two or more kinds thereof.

In view of obtaining the magnetic material paste having moderate viscosity, the content of the curing accelerator is preferably 0.1% by mass or more, 0.2% by mass or more, or 0.3% by mass or more, when the amount of nonvolatile components in the magnetic material paste is defined as 100% by mass. The upper limit of the content is preferably 3% by mass or less, 2% by mass or less, or 1% by mass or less.

### (e) Other Additives

The magnetic material paste may contain other additives, if necessary. Examples of the other additives include resin additives including a curing retardant such as triethyl borate, a flame retardant, a thickener, a defoamer, an inorganic filler (except for a magnetic powder), a leveling agent, an adhesion-imparting agent, and a colorant.

In view of sufficiently filling the opening of the internal layer substrate (as a result, forming a desired magnetic material layer), the viscosity (25°C) of the magnetic material paste is preferably 20 Pa·s or more, more preferably 30 Pa·s or more, and further preferably 40 Pa·s or more, and generally 250 Pa·s or less, preferably 220 Pa·s or less, and more preferably 200 Pa·s or less. The viscosity can be measured by using an E-type viscometer with the temperature of the magnetic material paste kept to 25±2°C.

Examples of a method for filling the opening of the internal layer substrate with the magnetic material paste include a method for filling the opening with the magnetic material paste by a squeegee, a method for filling the opening with the magnetic material paste by a cartridge, a method for filling the opening with the magnetic material paste by mask-printing, a roll-coating method, and an inkjet method. In view of filling the opening without voids, it is suitable that the opening be filled with the magnetic material paste under reduced pressure or in a vacuum.

After filling of the opening of the internal layer substrate with the magnetic material paste, the magnetic material paste is thermally cured to form the magnetic material layer. A thermal curing condition of the magnetic material paste depends on the composition and kind of the magnetic material paste. The curing temperature is preferably 120°C or higher, and more preferably 130°C or higher, or 140°C or higher, and preferably 240°C or lower, and more preferably 220°C or lower, or 200°C or lower. The curing time is preferably 5 minutes or more, and more preferably 10 minutes or more, or 15 minutes or more, and preferably 120 minutes or less, and more preferably 100 minutes or less, or 90 minutes or less.

Before thermal curing of the magnetic material paste, the magnetic material paste may be subjected to a preheating treatment, in which heating is carried out at a temperature lower than the curing temperature. Before thermal curing of the magnetic material paste, for example, the magnetic material paste may be preheated generally at a temperature of 50°C or higher and lower than 150°C (preferably 60°C or higher and 140°C or lower, and more preferably 70°C or higher and 130°C or lower) for 5 minutes or more (preferably 5 minutes to 150 minutes, and more preferably 15 minutes to 120 minutes).

The magnetic material layer 22 is thus formed in the opening 21 of the internal layer substrate 20 (Fig. 4). It is suitable that the magnetic material layer 22 be formed to be protruded from the internal layer substrate 20, and the redundant portion of the magnetic material layer 22 that is protruded from or adhered to the internal layer substrate 20 be then polished for removal, and made flat and smooth. Thus, as schematically illustrated in Fig. 4, the magnetic material layer 22 can be formed inside the opening 21 of the internal layer substrate 20 so that the first and the second main surfaces of the magnetic material layer 22 substantially correspond to the first and the second main surfaces of the internal layer substrate 20, respectively, in the direction perpendicular to the main surface of the substrate (in the thickness direction of the substrate). Examples of a polishing method in this case include buffing, belt polishing, and roll polishing. Examples of a commercially available polishing device include a buffing device NT-700IM and a ceramic roll polishing device #1500 manufactured by Ishii Hyoki Co., Ltd..

### Step (C)

In the step (C), the first through hole is formed to penetrate the first and the second main surfaces of the magnetic material layer.

In order to form a desired conductor coil, a plurality of first through holes 23 are formed in the magnetic material layer 22 (Fig. 5). For example, when the winding number N of the conductor coil is 1, four through holes may be provided as illustrated in Fig. 1. When the winding number N of the conductor coil is 2, six through holes may be provided as illustrated in Fig. 16. The number of the first through holes may be determined as appropriate according to a desired design of conductor coil. It should be noted that the schematic cross-sectional view illustrated in Fig. 5 corresponds to the cross section of the wiring substrate taken along the dash-dot-dash line X1-X1 in Fig. 1 and only two first through holes 23 are illustrated.

In consideration of characteristics of the internal layer substrate 22 and the size of the first through holes 23, the first through holes 23 can be formed by, for example, a known method using a drill, a laser, plasma, or an etching medium. The shape of the first through holes 23 is as described above. The size of the first through holes and the pitch therebetween are not particularly limited as long as they can achieve the desired design of the conductor coil in relation to the size of the opening 21 of the internal layer substrate 20 (corresponding to the size of the magnetic material layer 22) .

In view of achieving a wiring substrate having more excellent inductance characteristics, it is preferable that the positions of the first through holes be determined, in consideration of the cylindrical structure defined by the solenoid-shaped conductor pattern (conductor coil) formed at the step (G) noted below, so that a sufficient magnetic material is present at an outside region in an axial direction of the cylindrical structure as well as at an outside region in a side face direction of the cylindrical structure. For example, when the diameter of the first through holes is defined as D1, distance from the center of the first through hole to the internal layer substrate in the cylindrical axial direction (in Figs. 1 and 16, the vertical direction of the drawing sheets) of the conductor coil is preferably 0.7D1 or more, and more preferably 0.8D1 or more, 0.9D1 or more, or D1 or more. Distance from the center of the first through hole to the internal layer substrate in the cylindrical side face direction (a direction perpendicular to the cylindrical axial direction of the conductor coil; in Figs. 1 and 16, a horizontal direction of the drawing sheets) of the conductor coil are preferably 0.7D1 or more, and more preferably 0.8D1 or more, 0.9D1 or more, or D1 or more.

### Step (D)

In the step (D), the insulator is provided inside the first through hole.

The step (D) is not particularly limited as long as the insulator can be provided inside each of the first through holes. For example, an insulating hole-embedding paste containing an insulating resin is filled into the first through holes, and then the insulating hole-embedding paste may be thermally cured to form the insulators.

The composition of the insulating hole-embedding paste is not particularly limited as long as it can be filled into the first through hole and can form the insulator by thermal curing. For example, the insulating hole-embedding paste may contain the insulating resin and if necessary, may further contain an inorganic filler (except for the magnetic powder), a curing accelerator, and other additive.

As the insulating resin, the binder resin described in the aforementioned magnetic material paste may be used. Suitable kinds and properties are the same as those of the binder resin. The content of the insulating resin is preferably 1% by mass or more, 3% by mass or more, or 5% by mass or more, when the amount of nonvolatile components in the insulating hole-embedding paste is defined as 100% by mass. The upper limit of the content is not particularly limited and is preferably 90% by mass or less, 80% by mass or less, or 70% by mass or less.

Examples of the inorganic filler (except for the magnetic powder) include silica, alumina, glass, cordierite, silicon oxide, barium sulfate, talc, clay, a mica powder, aluminum hydroxide, magnesium hydroxide, calcium carbonate, magnesium carbonate, magnesium oxide, boron nitride, aluminum nitride, manganese nitride, aluminum borate, barium titanate, strontium titanate, calcium titanate, magnesium titanate, bismuth titanate, titanium oxide, barium zirconate, calcium zirconate, zirconium phosphate, and zirconium phosphate tungstate. Among these, silica such as amorphous silica, fused silica, crystalline silica, synthetic silica, or hollow silica is particularly suitable. It is preferable that silica be spherical silica. The inorganic filler may be used alone or in combination of two or more kinds thereof.

In view of achieving sufficient filling properties, the average particle diameter of the inorganic filler is preferably within a range of 0.01 µm to 4 µm, more preferably 0.05 µm to 2 µm, further preferably 0.1 µm to 1 µm, and still more preferably 0.3 µm to 0.8 µm. The average particle diameter of the inorganic filler can be measured using the same method as described in the average particle diameter of the magnetic powder.

In view of enhancing humidity resistance and dispersibility, it is preferable that the inorganic filler be treated with one or more kinds of surface treatment agents such as an aminosilane-based coupling agent, an epoxysilane-based coupling agent, a mercaptosilane-based coupling agent, an alkoxysilane compound, an organosilazane compound, and a titanate-based coupling agent.

The content of the inorganic filler is preferably 5% by mass or more, 10% by mass or more, or 20% by mass or more, and preferably 95% by mass or less, 90% by mass or less, or 80% by mass or less, when the amount of nonvolatile components in the insulating hole-embedding paste is defined as 100% by mass.

As for the curing accelerator and the other additives, those described in relation to the magnetic material paste may be used.

Filling of the first through holes with the insulating hole-embedding paste and thermal curing of the insulating hole-embedding paste may be carried out using the same method and under the same conditions as in the Step (B).

The insulator 24 is thus formed in each of the first through holes 23 of the magnetic material layer 22 (Fig. 6). It is suitable that the insulator 24 be formed to be protruded from the magnetic material layer 22, and the redundant portion of the insulator 24 that is protruded from or adhered to the magnetic material layer 22 be then polished for removal, and made flat and smooth. Thus, as schematically illustrated in Fig. 6, the insulator 24 can be formed inside each of the first through holes 23 of the magnetic material layer 22 so that first and second main surfaces thereof substantially correspond to the first and the second main surfaces of the magnetic material layer 22, respectively, in the direction perpendicular to the main surface of the substrate (in the thickness direction of the substrate). Polishing may be carried out by the same method as in that described at the step (B).

### Step (E)

In the step (E), the second through hole is formed to penetrate the insulator.

A second through hole 25 is formed in the insulator 24 that is provided inside each of the first through holes 23 of the magnetic material layer 22 (Fig. 7; also see Fig. 5 and 6). Therefore, the number of the second through holes 25 may be generally the same as the number of the first through holes 23. For example, when the winding number N of the conductor coil is 1, four first through holes are provided as illustrated in Fig. 1, and the insulator may be formed in each of the first through holes, and then the second through hole may be formed in each of them. When the winding number N of the conductor coil is 2, six first through holes are provided as illustrated in Fig. 16, and the insulator may be formed in each of the first through holes, and then the second through hole may be formed in each of them. It should be noted that the schematic cross-sectional view illustrated in Fig. 7 corresponds to the cross section of the wiring substrate taken along the dash-dot-dash line X1-X1 in Fig. 1 and only two second through holes 25 are illustrated.

In consideration of characteristics of the insulator 24 and the size of the second through holes 25, the second through holes 25 can be formed by, for example, a known method using a drill, a laser, plasma, or an etching medium. The shape of the second through holes 25 is as described above. The size of the second through holes and the pitch therebetween are not particularly limited as long as they can achieve the desired design of conductor coil in relation to the size of the first opening. For example, when the diameter of the first through holes is defined as D1, the diameter D2 of the second through holes is preferably 0.8D1 or less, and more preferably 0.7D1 or less, 0.6D1 or less, or 0.5D1 or less, and preferably 0.2D1 or more, and more preferably 0.3D1 or more. When the diameter D2 of the second through holes falls within such a range, the insulator having sufficient thickness is present between the magnetic material layer and the through hole conductor, which can further improve the inductance characteristics. It is suitable that the positions of the second through holes be determined so that the pitch of the second through holes is substantially the same as the pitch of the first through holes.

### Step (F)

In the step (F), the through hole conductor is formed inside the second through holes.

Before formation of the through hole conductor, it is preferable that the inside of the second through holes and the surface of the substrate be subjected to a desmear treatment. As for the desmear treatment, a known desmear treatment that can be used in formation of an interlayer conductor for production of the wiring substrate may be carried out, and a dry or wet desmear treatment may be carried out. Examples of the dry desmear treatment include a plasma treatment. Examples of the wet desmear treatment include a method for carrying out a swelling treatment using a swelling solution, a roughening treatment using an oxidant, and a neutralization treatment using a neutralization solution in this order.

The through hole conductor may be formed by plating the second through holes. For example, a plating seed layer may be formed by electroless plating, and then a metal layer may be formed on the plating seed layer by electrolytic plating to form the through hole conductor.

The structure of the through hole conductor is not limited as long as it can form the conductor coil in combination with the first and the second conductor patterns described below. For example, the through hole conductor may be a hollow cylindrical conductor (conformal-through hole conductor) in which a through hole wall is plated, or a columnar conductor (filled through hole conductor) in which the through hole is filled with a conductor.

When forming a conformal-through hole conductor as the through hole conductor, the inside of the hollow cylindrical conductor may be filled with the insulator. Filling with the insulator may be carried out in the same manner as in the step (D). For example, the insulating hole-embedding paste is filled into the second through holes, and then the insulating hole-embedding paste may be thermally cured to form the insulator. It is suitable that the insulator be formed to be protruded from the second through holes, and the redundant portion of the insulator that is protruded from or adhered to the second through holes be then polished for removal, and made flat and smooth. Polishing may be carried out by the same method as in that described at the step (B).

Examples of a conductive material constituting the through hole conductor include one or more metals selected from the group consisting of gold, platinum, palladium, silver, copper, aluminum, cobalt, chromium, zinc, nickel, titanium, tungsten, iron, tin, and indium. The through hole conductor may be formed from a single metal or an alloy. Examples of the alloy include an alloy of two or more kinds of metals selected from the aforementioned group (e.g., nickel-chromium alloy, copper-nickel alloy, and copper-titanium alloy).

### Step (G)

In the step (G), the first and the second conductor patterns are formed on the first and the second main surfaces of the magnetic material layer, respectively, to connect the first and the second conductor patterns to the through hole conductor in a solenoid shape.

Before formation of the first and the second conductor patterns, it is preferable that the surface of the substrate be subjected to a desmear treatment. As for the desmear treatment, a known desmear treatment that can be used in formation of a circuit conductor for production of the wiring substrate may be carried out, and a dry or wet desmear treatment may be carried out. Examples of the desmear treatment are as described in the step (F).

The first and the second conductor patterns may be formed by a known technique for forming a conductor pattern (circuit conductor) such as a subtractive method or a semi-additive method.

For example, in the subtractive method, an unnecessary portion (non-circuit forming portion) of a plating conductor layer is selectively removed by etching or the like, to form the conductor pattern. The conductor pattern may be formed by the subtractive method in accordance with a known procedure. For example, formation of the conductor pattern using the subtractive method may be carried out by a method including: i) providing a plating seed layer on the surface of the substrate by electroless plating; ii) providing a metal layer on the plating seed layer by electrolytic plating, to form a conductor layer; iii) providing an etching resist (dried film) on a surface of the conductor layer; iv) exposing and developing the etching resist to form a wiring pattern; v) removing the exposed conductor layer by etching; and vi) removing the etching resist.

In the semi-additive method, a non-circuit forming portion of a plating seed layer is protected with a plating resist; a metal such as copper is thickly applied to a circuit forming portion by electrolytic plating; the plating resist is removed; and then the plating seed layer except for the circuit forming portion is removed by etching to form the conductor pattern. The conductor pattern may be formed by the semi-additive method in accordance with a known procedure. For example, formation of the conductor pattern using the semi-additive method may be carried out by a method including: i) providing a plating seed layer on the surface of the substrate by electroless plating; ii) providing a plating resist (dry film) on a surface of the plating seed layer; iii) exposing and developing the plating resist to form a wiring pattern; iv) carrying out electrolytic plating through the plating resist; v) removing the plating resist; and vi) removing the plating seed layer except for the circuit forming portion by etching.

The structure (pattern) of the first conductor pattern is not limited as long as it can form the conductor coil in combination with the through hole conductor and the second conductor pattern. For example, the first conductor pattern may include the through hole land 28a and the connection pattern 28b that connects the through hole land to another through hole land (Fig. 1). Similarly, the second conductor pattern may include the through hole land 29a and the connection pattern 29b that connects the through hole land to another through hole land (Fig. 1; the through hole land 29a is not illustrated).

The first and the second conductor patterns are connected to the through hole conductor to form the solenoid-shaped conductor pattern (conductor coil). As a result, an inductor function is expressed.

As described above, the first conductor pattern formed "on the first main surface of the magnetic material layer" includes the first conductor pattern that is provided directly in contact with the first main surface of the magnetic material layer. Similarly, the second conductor pattern formed "on the second main surface of the magnetic material layer" includes the second conductor pattern that is provided directly in contact with the second main surface of the magnetic material layer.

In an embodiment (referred to as "first embodiment") in which the steps (A) to (G) are carried out so that the first and the second conductor patterns are provided directly in contact with the first and the second main surfaces of the magnetic material layer, respectively, the wiring substrate 100 illustrated in Fig. 8 can be produced. In the wiring substrate 100 illustrated in Fig. 8, the first conductor pattern 28 and the second conductor pattern 29 are provided in contact with the first main surface and the second main surface of the magnetic material layer 22, respectively.

On the other hands, the steps (A) to (G) may be carried out so that the first and the second conductor patterns are provided through other layer on the first and the second main surfaces of the magnetic material layer, respectively. Hereinafter, such a reference embodiment is described which is not within the scope of the claims. The other layer is not particularly limited as long as it does not inhibit the effects of the present invention. Examples thereof include an insulating layer.

Hereinafter, the reference embodiment will be described according to reference aspects in which an insulating layer is used as the other layer.

In the reference embodiment, the method for producing a wiring substrate further includes, after the step (D), at least one of a step (D-1) of providing the insulating layer in contact with the first main surface of the internal layer substrate and the first main surface of the magnetic material layer, and a step (D-2) of providing the insulating layer in contact with the second main surface of the internal layer substrate and the second main surface of the magnetic material layer.

The steps (D-1) and/or (D-2) are not particularly limited as long as the insulating layer can be provided in contact with the main surface of the substrate. A known method that can be used in formation of the insulating layer of the wiring substrate may be carried out. For example, the insulating layer may be provided by using an insulating adhesion film having an insulating adhesion layer, specifically, by laminating the insulating adhesion layer in contact with the main surface of the substrate and thermally curing the insulating adhesion layer.

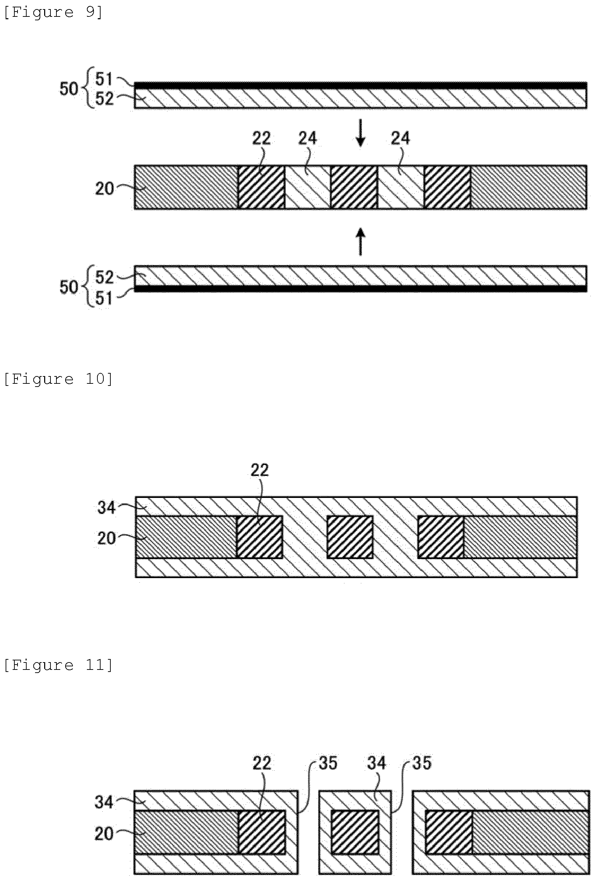

For example, the steps (D-1) and (D-2) may be carried out using the insulating adhesion film, as illustrated in Fig. 9. In Fig. 9, an insulating adhesion film 50 is laminated onto both of the main surfaces of the substrate obtained in the step (D) (the substrate in which the insulator 24 is provided into each of the first through holes of the magnetic material layer 22, as illustrated in Fig. 6). The insulating adhesion film 50 includes a support 51 and an insulating adhesion layer 52 provided in contact with the support. The insulating adhesion film 50 is laminated onto both of the main surfaces of the substrate so that the insulating adhesion layer 52 is in contact with the main surfaces of the substrate.

Examples of the support 51 include a film formed from a plastic material, a metal foil, and a release paper. A film formed from a plastic material and a metal foil are preferable.

When using a film formed from a plastic material, examples of the plastic material include polyesters such as polyethylene terephthalate (PET) and polyethylene naphthalate (PEN), polycarbonate (PC), acryl such as polymethyl methacrylate (PMMA), cyclic polyolefins, triacetylcellulose (TAC), polyether sulfide (PES), polyether ketones, and polyimides.

When using a metal foil, examples of the metal foil include a copper foil and an aluminum foil. A copper foil is preferable. As for the copper foil, a foil formed from a single metal copper may be used, or a foil formed from an alloy of copper and another metal (e.g., tin, chromium, silver, magnesium, nickel, zirconium, silicon, and titanium) may be used.

The thickness of the support is not particularly limited and is preferably within a range of 5 µm to 75 µm, and more preferably 10 µm to 60 µm.

A composition of the insulating adhesion layer 52 is not particularly limited as long as a cured product thereof has sufficient insulating properties. For example, the insulating adhesion layer 52 may include a resin composition containing a thermosetting resin, and if necessary, further containing a component such as a curing agent, an inorganic filler, a curing accelerator, a thermoplastic resin, an organic filler, or a flame retardant. As for the thermosetting resin, the curing agent, the inorganic filler, the curing accelerator, and the thermoplastic resin, those described in relation to the magnetic material paste and the insulating hole-embedding paste may be used. As for the insulating adhesion layer for forming the insulating layer of the wiring substrate, many insulating adhesion layers are disclosed in, for example, JP-A-2018-100421, JP-A-2017-171925, and JP-A-2016-20480. The insulating adhesion layer may be selected from the known insulating adhesion layers according to desired characteristics.

The thickness of the insulating adhesion layer 52 is, depending on design details of the wiring substrate, preferably 100 µm or less, more preferably 80 µm or less, and further preferably 60 µm or less, or 50 µm or less in view of thinning the wiring substrate. The lower limit of the thickness of the insulating adhesion layer 52 may be generally 5 µm or more, or 10 µm or more.

The lamination of the adhesion film 50 and the substrate may be carried out by a vacuum lamination method. In the vacuum lamination method, the thermal pressing temperature is preferably within a range of 60°C to 160°C, and more preferably 80°C to 140°C, the thermal pressing pressure is preferably within a range of 0.098 MPa to 1.77 MPa, and more preferably 0.29 MPa to 1.47 MPa, and the thermal pressing time is preferably within a range of 20 seconds to 400 seconds, and more preferably 30 seconds to 300 seconds. It is preferable that the lamination is carried out under a reduced pressure condition of 26.7 hPa or less. The lamination can be carried out by a commercially available vacuum laminator. Examples of the commercially available vacuum laminator include a vacuum pressure laminator manufactured by Meiki Co., Ltd., and a vacuum applicator manufactured by Nikko-Materials Co., Ltd.

After the lamination, the insulating adhesion layer 52 is thermally cured to form the insulating layer. A condition for thermally curing the insulating adhesion layer 52 may be the same as the conditions of thermal curing of the magnetic material paste and the insulating hole-embedding paste.

The support 51 may be peeled before or after thermal curing of the insulating adhesion layer. When a metal foil is used as the support 51, the first and the second conductor patterns may be formed using the metal foil without peeling and removing the metal foil. Hereinafter, an embodiment in which the support is peeled off, and an embodiment in which the conductor pattern is formed using a support metal foil will be separately described.

### Embodiment in which Support is Peeled off

When the support 51 is peeled off, a substrate illustrated in Fig. 10 is obtained. In the substrate illustrated in Fig. 10, the insulating layer 34 is provided in contact with the first and the second main surfaces of the insulating layer 20 and the magnetic material layer 22. In Fig. 10, an insulating member derived from the insulator 24 that is provided inside the first through holes of the magnetic material layer 22 (Fig. 9) is not distinguished from the insulating layer 34 obtained by thermally curing an insulating resin layer 52. However, the composition of the insulator 24 may be the same as or different from that of the insulating layer 34.

After forming the insulating layer 34, the step (E) may be carried out. In this embodiment, second through holes 35 that penetrate not only the insulator 24 but also the insulating layer 34 are formed in the step (E) (Fig. 11; also see Figs. 9 and 10). The number and size of the second through holes and the pitch therebetween are as described above.

After forming the second through holes, the step (F) is carried out. As a result, the through hole conductor 36 can be formed inside each of the second through holes 35. Subsequently, the step (G) is carried out to connect the first conductor pattern 38 and the second conductor pattern 39 to the through hole conductor 36. Thus, the solenoid-shaped conductor pattern (conductor coil) can be formed and the wiring substrate 200 illustrated in Fig. 12 is obtained. In the wiring substrate 200, the first conductor pattern 38 is provided in contact with the surface of the insulating layer 34 on the first main surface of the magnetic material layer 22, and the second conductor pattern 39 is provided in contact with the surface of the insulating layer 34 on the second main surface of the magnetic material layer 22.

### Embodiment in which Conductor Pattern is formed using Support Metal Foil

When a metal foil is used as the support 51, the first and the second conductor patterns may be formed using the metal foil without peeling off the metal foil.

In this embodiment, a substrate illustrated in Fig. 13 is obtained. In the substrate illustrated in Fig. 13, the insulating layer 34 is provided in contact with the first and the second main surfaces of the insulating layer 20 and the magnetic material layer 22, and the support metal foil 51 is provided in contact with the insulating layer 34. In Fig. 13, an insulating member derived from the insulator 24 that is provided inside the first through holes of the magnetic material layer 22 (Fig. 9) is not distinguished from the insulating layer 34 obtained by thermally curing the insulating resin layer 52, similarly to Fig. 10. However, the composition of the insulator 24 may be the same as or different from that of the insulating layer 34.

For such a substrate, the step (E) may be carried out. In this embodiment, second through holes 45 that penetrate not only the insulator 24 but also the insulating layer 34 and the support metal foil 51 are formed in the step (E) (Fig. 14; also see Figs. 9 and 13). The number and size of the second through holes and the pitch therebetween are as described above.

After forming the second through holes, the step (F) is carried out. As a result, the through hole conductor 46 can be formed inside each of the second through holes 45. Subsequently, the step (G) is carried out to connect the first conductor pattern 48 and the second conductor pattern 49 to the through hole conductor 46. Thus, the solenoid-shaped conductor pattern (conductor coil) can be formed. In the step (G), the first conductor pattern 48 and the second conductor pattern 49 may be formed by a technique for forming a conductor pattern, such as a subtractive method or a semi-additive method (modified semi-additive method) using the support metal foil 51. For example, in the subtractive method, an unnecessary portion (non-circuit forming portion) of the support metal foil is selectively removed by etching or the like, to form the conductor pattern. For example, formation of the conductor pattern using the subtractive method may be carried out by a method including: i) providing an etching resist (dry film) on a surface of the support metal foil; ii) exposing and developing the etching resist to form a wiring pattern; iii) removing the exposed support metal foil by etching; and iv) removing the etching resist. In the semi-additive method, the conductor pattern may be formed by using the support metal foil as the plating seed layer. For example, formation of the conductor pattern using the semi-additive method may be carried out by a method including: i) providing a plating resist (dry film) on a surface of the support metal foil (plating seed layer); ii) exposing and developing the plating resist to form a wiring pattern; iii) carrying out electrolytic plating through the plating resist; iv) removing the plating resist; and v) removing the support metal foil except for the circuit forming portion by etching.

The wiring substrate 300 illustrated in Fig. 15 is thus obtained. In the wiring substrate 300, the first conductor pattern 48 is provided in contact with the surface of the insulating layer 34 on the first main surface of the magnetic material layer 22, and the second conductor pattern 49 is provided in contact with the surface of the insulating layer 34 on the second main surface of the magnetic material layer 22.

When the insulating layer 34 is provided in contact with at least one of the first and the second main surfaces of the internal layer substrate 20 (Figs. 12 and 15), the method for producing a wiring substrate of the present invention may further include a step of producing a conductor layer that is provided in contact with the surface of the insulating layer. Therefore, in an embodiment, the method for producing a wiring substrate of the present invention further includes the step of providing a conductor layer on the surface of the insulating layer on at least one of the first and the second main surfaces of the internal layer substrate.

The method for producing a wiring substrate of the present invention may further include a step of alternately providing the insulating layer and the conductor layer (wiring layer) on at least one of the first and the second main surfaces of the internal layer substrate 20 (and the magnetic material layer 22) to form a multi-layer wiring. As for design details of the insulating layer, the wiring layer, and the multi-layer wiring, any layer constitution and design known in production of a wiring substrate may be used. For example, when using the wiring substrates illustrated in Figs. 8, 12, and 15 as an internal layer circuit substrate, and alternately providing the insulating layer and the conductor layer onto the internal layer circuit substrate, there can be produced a wiring substrate with built-in inductor structure and including a multi-layer wiring.

### EXAMPLES

Hereinafter, the present invention will be described more specifically by referring to Examples. However, the invention is not limited to the following examples.

### Example 1 (reference)

### 1-A. Preparation of Internal layer substrate having Opening

An internal layer substrate with a thickness of 0.8 mm ("MCL-E-705GL," copper foil-etched out product, available from Hitachi Chemical Co., Ltd.) was prepared. A circular opening with a diameter of 1.4 mm was formed in the internal layer substrate by a drill. In the formation of the opening, a drill "ST" manufactured by UNION TOOL CO., was used, and the revolution speed was 46,000 rpm.

### 1-B. Formation of Magnetic Material Layer

The opening with a diameter of 1.4 mm was subjected to vacuum printing using a magnetic material paste. As the magnetic material paste, a material containing a magnetic powder in a content of 90% by mass and having a viscosity of 60 Pa·sec (measurement environment: E-type viscometer, 25°C, 5 rpm) and a specific magnetic permeability of 7 at 100 MHz was used. After the vacuum printing, the magnetic material paste was heated at 130°C for 30 minutes and then at 145°C for 30 minutes to be thermally cured. As a result, a magnetic material layer was provided inside the opening. Subsequently, the surfaces of the internal layer substrate and the magnetic material layer were polished and made smooth. In the polishing, a ceramic polishing roll #1500 manufactured by Ishii Hyoki Co., Ltd., was used.

### 1-C. Formation of First Through Hole

As illustrated in Fig. 1, four first through holes with a diameter of 0.3 mm (horizontal pitch: 0.6 mm; vertical pitch: 0.5 mm) were formed in the magnetic material layer with a diameter of 1.4 mm by a drill. In the formation of the first through holes, a drill "UV" manufactured by UNION TOOL CO., was used, and the revolution speed was 60,000 rpm.

### 1-D. Formation of Insulator

Each of the first through holes with a diameter of 0.3 mm was subjected to vacuum printing using an insulating hole-embedding paste ("IR-10F," available from SAN-EI KAGAKU CO., LTD.). After the vacuum printing, the insulating hole-embedding paste was heated at 110°C for 30 minutes and then at 150°C for 60 minutes to be thermally cured. As a result, an insulator was provided inside each of the first through holes. Subsequently, a surface of the insulator was polished and made smooth. In the polishing, a ceramic polishing roll #1500 manufactured by Ishii Hyoki Co., Ltd., was used.

### 1-D'. Formation of Insulating Layer

Next, an insulating adhesion film ("ABF-GX92R," thickness of insulating resin layer: 30 µm, support PET, available from Ajinomoto Fine-Techno Co., Inc.) was laminated onto both surfaces of the substrate by vacuum lamination so that the insulating resin layer was in contact with the surfaces of the substrate. After the vacuum lamination, the insulating resin layer was heated at 100°C for 30 minutes and then at 180°C for 30 minutes to be thermally cured. As a result, an insulating layer was obtained.

### 1-E. Formation of Second Through Hole

A second through hole with a diameter of 0.15 mm (n=4) was formed in each of the insulators with a diameter of 0.3 mm by a drill. The positions of the second through holes were adjusted so that the centers of the second through holes were disposed at the centers of the first through holes (the insulator with a diameter of 0.3 mm). In the formation of the second through holes, a drill "NEU" manufactured by UNION TOOL CO., was used, and the revolution speed was 80,000 rpm.

### 1-F. Formation of Through Hole Conductor

The inside of the second through holes and the surface of the substrate were subjected to a desmear treatment, electroless plating (thickness: 0.7 µm), and electrolytic plating (thickness: 22 µm), to form a through hole conductor (conformal type) in each of the second through holes.

After the formation of the through hole conductor, each of the second through holes was subjected to vacuum printing using an insulating hole-embedding paste ("IR-10F," available from SAN-EI KAGAKU CO., LTD.). After the vacuum printing, the insulating hole-embedding paste was heated at 110°C for 30 minutes and then at 150°C for 60 minutes to be thermally cured. As a result, an insulator was provided. Subsequently, a surface of the insulator was polished and made smooth. In the polishing, a ceramic polishing roll #1500 manufactured by Ishii Hyoki Co., Ltd., was used.

### 1-G. Formation of Solenoid-shaped conductor Pattern

The surface of the substrate was subjected to a desmear treatment, electroless plating (thickness: 0.7 µm), and electrolytic plating (thickness: 22 µm), to form a conductor layer. Onto the conductor layer, a dry film was laminated, and was exposed and developed, and then was patterned. Subsequently, a conductor pattern was formed by a subtractive method using an iron chloride etchant, and the dry film was then peeled off. As illustrated in Fig. 1, a conductor pattern was formed on both surfaces of the substrate. Specifically, the conductor patterns were formed on the surfaces of the substrate so that the conductor patterns and the through hole conductor were connected to each other in a solenoid shape, thus building an inductor structure into the wiring substrate.

### Example 2 (reference)

### 2-A. Preparation of Internal layer substrate having Opening

An internal layer substrate with a thickness of 0.8 mm ("MCL-E-705GL," copper foil-etched out product, available from Hitachi Chemical Co., Ltd.) was prepared. A circular opening with a diameter of 1.4 mm was formed in the internal layer substrate by a drill. In the formation of the opening, a drill "ST" manufactured by UNION TOOL CO., was used, and the revolution speed was 46,000 rpm.

### 2-B. Formation of Magnetic Material Layer

The opening with a diameter of 1.4 mm was subjected to vacuum printing using a magnetic material paste. As the magnetic material paste, a material containing a magnetic powder in a content of 90% by mass and having a viscosity of 60 Pa·sec (measurement environment: E-type viscometer, 25°C, 5 rpm) and a specific magnetic permeability of 7 at 100 MHz was used. After the vacuum printing, the magnetic material paste was heated at 130°C for 30 minutes and then at 145°C for 30 minutes to be thermally cured. As a result, a magnetic material layer was provided inside the opening. Subsequently, the surfaces of the internal layer substrate and the magnetic material layer were polished and made smooth. In the polishing, a ceramic polishing roll #1500 manufactured by Ishii Hyoki Co., Ltd., was used.

### 2-C. Formation of First Through Hole

As illustrated in Fig. 1, four first through holes with a diameter of 0.3 mm (horizontal pitch: 0.6 mm; vertical pitch: 0.5 mm) were formed in the magnetic material layer with a diameter of 1.4 mm by a drill. In the formation of the first through holes, a drill "UV" manufactured by UNION TOOL CO., was used, and the revolution speed was 60,000 rpm.

### 2-D. Formation of Insulator

Each of the first through holes with a diameter of 0.3 mm was subjected to vacuum printing using an insulating hole-embedding paste ("IR-10F," available from SAN-EI KAGAKU CO., LTD.). After the vacuum printing, the insulating hole-embedding paste was heated at 110°C for 30 minutes and then at 150°C for 60 minutes to be thermally cured. As a result, an insulator was provided inside each of the first through holes. Subsequently, a surface of the insulator was polished and made smooth. In the polishing, a ceramic polishing roll #1500 manufactured by Ishii Hyoki Co., Ltd., was used.

### 2-D'. Formation of Insulating Layer

Next, an insulating adhesion film ("ABF-GX92-RCC," thickness of insulating resin layer: 30 µm, support copper foil, available from Ajinomoto Fine-Techno Co., Inc.) was laminated onto both surfaces of the substrate so that the insulating resin layer was in contact with the surfaces of the substrate by vacuum lamination. After the vacuum lamination, the insulating resin layer was heated at 100°C for 30 minutes and then at 180°C for 30 minutes to be thermally cured. As a result, an insulating layer was obtained.

### 2-E. Formation of Second Through Hole

A second through hole with a diameter of 0.15 mm (n=4) was formed in each of the insulators with a diameter of 0.3 mm by a drill. The positions of the second through holes were adjusted so that the centers of the second through holes were disposed at the centers of the first through holes (the insulator with a diameter of 0.3 mm). In the formation of the second through holes, a drill "NEU" manufactured by UNION TOOL CO., was used, and the revolution speed was 80,000 rpm.

### 2-F. Formation of Through Hole Conductor

The inside of the second through holes and the surface of the substrate were subjected to a desmear treatment, electroless plating (thickness: 0.7 and electrolytic plating (thickness: 22 µm), to form a through hole conductor (conformal type) in each of the second through holes.

After the formation of the through hole conductor, each of the second through holes was subjected to vacuum printing using an insulating hole-embedding paste ("IR-10F," available from SAN-EI KAGAKU CO., LTD.). After the vacuum printing, the insulating hole-embedding paste was heated at 110°C for 30 minutes and then at 150°C for 60 minutes to be thermally cured. As a result, an insulator was provided. Subsequently, a surface of the insulator was polished and made smooth. In the polishing, a ceramic polishing roll #1500 manufactured by Ishii Hyoki Co., Ltd., was used.

### 2-G. Formation of Solenoid-shaped conductor Pattern

The surface of the substrate was subjected to a desmear treatment, electroless plating (thickness: 0.7 µm), and electrolytic plating (thickness: 22 µm), and a conductor layer was formed with the support copper foil. Onto the conductor layer, a dry film was laminated, and was exposed and developed, and was patterned. Subsequently, a conductor pattern was formed by a subtractive method using an iron chloride etchant, and the dry film was then peeled off. As illustrated in Fig. 1, a conductor pattern was formed on both surfaces of the substrate. Specifically, the conductor patterns were formed on the surfaces of the substrate so that the conductor patterns and the through hole conductor were connected to each other in a solenoid shape, thus building an inductor structure into the wiring substrate.

### Example 3

### 3-A. Preparation of Internal layer substrate having Opening

An internal layer substrate with a thickness of 0.8 mm ("MCL-E-705GL," copper foil-etched out product, available from Hitachi Chemical Co., Ltd.) was prepared. A circular opening with a diameter of 1.4 mm was formed in the internal layer substrate by a drill. In the formation of the opening, a drill "ST" manufactured by UNION TOOL CO., was used, and the revolution speed was 46,000 rpm.

### 3-B. Formation of Magnetic Material Layer

The opening with a diameter of 1.4 mm was subjected to vacuum printing using a magnetic material paste. As the magnetic material paste, a material containing a magnetic powder in a content of 90% by mass and having a viscosity of 60 Pa·sec (measurement environment: E-type viscometer, 25°C, 5 rpm) and a specific magnetic permeability of 7 at 100 MHz was used. After the vacuum printing, the magnetic material paste was heated at 130°C for 30 minutes and then at 145°C for 30 minutes to be thermally cured. As a result, a magnetic material layer was provided inside the opening. Subsequently, the surfaces of the internal layer substrate and the magnetic material layer were polished and made smooth. In the polishing, a ceramic polishing roll #1500 manufactured by Ishii Hyoki Co., Ltd., was used.

### 3-C. Formation of First Through Hole

As illustrated in Fig. 1, four first through holes with a diameter of 0.3 mm (horizontal pitch: 0.6 mm; vertical pitch: 0.5 mm) were formed in the magnetic material layer with a diameter of 1.4 mm by a drill.

In the formation of the first through holes, a drill "UV" manufactured by UNION TOOL CO., was used, and the revolution speed was 60,000 rpm.

### 3-D. Formation of Insulator

Each of the first through holes with a diameter of 0.3 mm was subjected to vacuum printing using an insulating hole-embedding paste ("IR-10F," available from SAN-EI KAGAKU CO., LTD.). After the vacuum printing, the insulating hole-embedding paste was heated at 110°C for 30 minutes and then at 150°C for 60 minutes to be thermally cured. As a result, an insulator was provided inside each of the first through holes. Subsequently, a surface of the insulator was polished and made smooth. In the polishing, a ceramic polishing roll #1500 manufactured by Ishii Hyoki Co., Ltd., was used.

### 3-E. Formation of Second Through Hole

A second through hole with a diameter of 0.15 mm (n=4) was formed in each of the insulators with a diameter of 0.3 mm by a drill. The positions of the second through holes were adjusted so that the centers of the second through holes were disposed at the centers of the first through holes (the insulator with a diameter of 0.3 mm). In the formation of the second through holes, a drill "NEU" manufactured by UNION TOOL CO., was used, and the revolution speed was 80,000 rpm.

### 3-F. Formation of Through Hole Conductor

The inside of the second through holes and the surface of the substrate were subjected to a desmear treatment, electroless plating (thickness: 0.7 µm), and electrolytic plating (thickness: 22 µm), to form a through hole conductor (conformal type) in each of the second through holes.

After the formation of the through hole conductor, each of the second through holes was subjected to vacuum printing using an insulating hole-embedding paste ("IR-10F," available from SAN-EI KAGAKU CO., LTD.). After the vacuum printing, the insulating hole-embedding paste was heated at 110°C for 30 minutes and then at 150°C for 60 minutes to be thermally cured. As a result, an insulator was provided. Subsequently, a surface of the insulator was polished and made smooth. In the polishing, a ceramic polishing roll #1500 manufactured by Ishii Hyoki Co., Ltd., was used.

### 3-G. Formation of Solenoid-shaped conductor Pattern

The surface of the substrate was subjected to a desmear treatment, electroless plating (thickness: 0.7 and electrolytic plating (thickness: 22 µm), to form a conductor layer. Onto the conductor layer, a dry film was laminated, and was exposed and developed, and was patterned. Subsequently, a conductor pattern was formed by a subtractive method using an iron chloride etchant, and the dry film was then peeled off. As illustrated in Fig. 1, the conductor pattern was formed on both surfaces of the substrate. Specifically, the conductor patterns were formed on the surfaces of the substrate so that the conductor patterns and the through hole conductor were connected to each other in a solenoid shape, thus building an inductor structure into the wiring substrate.

### Reference Numerals List

10, 10': inductor structure
20: internal layer substrate
20a: first main surface
20b: second main surface
21: opening (first opening)
22: magnetic material layer
23: first through hole (second opening)
24: insulator
25, 35, 45: second through hole (third opening)
26, 36, 46: through hole conductor
27, 37, 47: insulator (inside of conformal through hole conductor)
28, 38, 48: first conductor pattern
28a: through hole land
28b: connection pattern
29, 39, 49: second conductor pattern
29a: through hole land (not illustrated)
29b: connection pattern
34: insulating layer
50: insulating adhesion film
51: support
52: insulating adhesion layer
100, 200, 300: wiring substrate

## Claims

1. A wiring substrate (100) having an inductor function, the wiring substrate (100) comprising:
an internal layer substrate (20) that has first and second main surfaces (20a,20b) and an opening (21) formed to penetrate the first and the second main surfaces (20a,20b) ;
a magnetic material layer (22) that is provided inside the opening (21) and has a first through hole (23) formed to penetrate first and second main surfaces of the magnetic material layer (22);
an insulator (24) that is provided inside the first through hole (23) and has a second through hole (25) formed to penetrate the insulator (24);
an inductor including a first conductor pattern (28) formed on the first main surface of the magnetic material layer (22), a second conductor pattern (29) formed on the second main surface of the magnetic material layer (22), and a through hole conductor (26) provided inside the second through hole (25) and connecting the first conductor pattern (28) to the second conductor pattern (29);
wherein the first conductor pattern (28) is provided directly in contact with the first main surface of the magnetic material layer (22); **characterized in that**
the second conductor pattern (29) is provided directly in contact with the second main surface of the magnetic material layer (22).

2. The wiring substrate (100) according to claim 1,
wherein the internal layer substrate (20) is an insulating substrate.

3. The wiring substrate (100) according to any one of claims 1 to 2, wherein the internal layer substrate (20) is a circuit substrate.

4. The wiring substrate (100) according to any one of the preceding claims, wherein the internal layer substrate (20) has a plurality of openings, formed at predetermined intervals therebetween.

5. The wiring substrate (100) according to any one of the preceding claims, wherein a plurality of the first through holes are formed in the magnetic material layer (22).

6. The wiring substrate (100) according to any one of the preceding claims, wherein the insulator (24) has a thickness that is substantially the same as a thickness of the magnetic material layer (22).

7. The wiring substrate (100) according to any one of the preceding claims, wherein when a diameter of the first through hole is D1, a diameter D2 of the second through hole is 0.8D1 or less.

8. A method for producing a wiring substrate (100) having an inductor function according to any one of the preceding claims, the method comprising the following (A) to (G):
(A) preparing an internal layer substrate (20) that has first and second main surfaces (20a,20b) and an opening (21) formed to penetrate the first and the second main surfaces (20a,20b);
(B) filling the inside of the opening with a magnetic material paste and thermally curing the magnetic material paste to provide a magnetic material layer (22);
(C) forming a first through hole (23) to penetrate the first and the second main surfaces of the magnetic material layer (22);
(D) providing an insulator (24) inside the first through hole (23);
(E) forming a second through hole (25) to penetrate the insulator (24);
(F) forming a through hole conductor (26) inside the second through hole (25); and
(G) forming first and second conductor patterns (28,29) on the first and the second main surfaces of the magnetic material layer (22), respectively, to connect the first and the second conductor patterns (28,29) to a through hole conductor (26) in a solenoid shape.

9. The method according to claim 8, wherein the magnetic material paste has a viscosity (25°C) of 20 to 250 Pa·s.

10. Use of a wiring substrate (100) according to any one of claims 1 to 7, or produced by a method of any one of claims 8 to 9, in an electrical product such as a computer, a cellular phone, a digital camera, or television, or in a vehicle such as a motorcycle, an automobile, a train, a ship or an airplane.

## Patentansprüche

1. Verdrahtungssubstrat (100) mit Induktorfunktion, wobei das Verdrahtungssubstrat (100) Folgendes umfasst:
ein Innenschichtsubstrat (20) mit einer ersten und zweiten Hauptfläche (20a, 20b) und einer Öffnung (21), die zum Durchdringen der ersten und zweiten Hauptfläche (20a, 20b) ausgebildet ist;
eine Magnetmaterialschicht (22), die innerhalb der Öffnung (21) bereitgestellt ist und ein erstes Durchgangsloch (23) aufweist, das zum Durchdringen einer ersten und zweiten Hauptfläche der Magnetmaterialschicht (22) ausgebildet ist;
ein Isolierelement (24), das innerhalb des ersten Durchgangslochs (23) bereitgestellt ist und ein zweites Durchgangsloch (25) zum Durchdringen des Isolierelements (24) aufweist;
einen Induktor, der ein erstes Leitermuster (28), das auf der ersten Hauptfläche der Magnetmaterialschicht (22) ausgebildet ist, ein zweites Leitermuster (29), das auf der zweiten Hauptfläche der Magnetmaterialschicht (22) ausgebildet ist, und einen Durchgangslochleiter (26), der innerhalb des zweiten Durchgangslochs (25) bereitgestellt ist und das erste Leitermuster (28) mit dem zweiten Leitermuster (29) verbindet, umfasst;
wobei das erste Leitermuster (28) direkt in Kontakt mit der ersten Hauptfläche der Magnetmaterialschicht (22) bereitgestellt ist;
**dadurch gekennzeichnet, dass** das zweite Leitermuster (29) direkt in Kontakt mit der zweiten Hauptfläche der Magnetmaterialschicht (22) bereitgestellt ist.

2. Verdrahtungssubstrat (100) nach Anspruch 1, wobei das Innenschichtsubstrat (20) ein Isoliersubstrat ist.

3. Verdrahtungssubstrat (100) nach einem der Ansprüche 1 bis 2, wobei das Innenschichtsubstrat (20) ein Schaltungssubstrat ist.

4. Verdrahtungssubstrat (100) nach einem der vorangegangenen Ansprüche, wobei das Innenschichtsubstrat (20) eine Vielzahl von Öffnungen aufweist, die mit vorbestimmten Abständen dazwischen ausgebildet sind.

5. Verdrahtungssubstrat (100) nach einem der vorangegangenen Ansprüche, wobei eine Vielzahl der ersten Durchgangslöcher in der Magnetmaterialschicht (22) ausgebildet ist.

6. Verdrahtungssubstrat (100) nach einem der vorangegangenen Ansprüche, wobei das Isolierelement (24) eine Dicke aufweist, die im Wesentlichen gleich der Dicke der Magnetmaterialschicht (22) ist.

7. Verdrahtungssubstrat (100) nach einem der vorangegangenen Ansprüche, wobei, wenn ein Durchmesser des ersten Durchgangslochs D1 ist, ein Durchmesser D2 des zweiten Durchgangslochs 0,8D1 oder weniger ist.

8. Verfahren zum Herstellen eines Verdrahtungssubstrats (100) mit Induktorfunktion gemäß einem der vorangegangenen Ansprüche, wobei das Verfahren die folgenden Schritte (A) bis (G) umfasst:
(A) Bereitstellen eines Innenschichtsubstrats (20) mit einer ersten und zweiten Oberfläche (20a, 20b) und einer Öffnung (21), die zum Durchdringen der ersten und zweiten Hauptfläche (20a, 20b) ausgebildet ist;
(B) Befüllen des Öffnungsinneren mit einer Magnetmaterialpaste und Wärmehärten der Magnetmaterialpaste, um eine Magnetmaterialschicht (22) bereitzustellen;
(C) Ausbilden eines ersten Durchgangslochs (23) zum Durchdringen der ersten und zweiten Hauptfläche der Magnetmaterialschicht (22);
(D) Bereitstellen eines Isolierelements (24) innerhalb des ersten Durchgangslochs (23);
(E) Ausbilden eines zweiten Durchgangslochs (25) zum Durchdringen des Isolierelements (24);
(F) Ausbilden eines Durchgangslochleiters (26) innerhalb des zweiten Durchgangslochs (25); und
(G) jeweiliges Ausbilden eines ersten und zweiten Leitermusters (28, 29) auf der ersten und zweiten Hauptfläche der Magnetmaterialschicht (22), um das erste und zweite Leitermuster (28, 29) mit einem Durchgangslochleiter (26) mit einer Solenoidform zu verbinden.

9. Verfahren nach Anspruch 8, wobei die Magnetmaterialpaste eine Viskosität (25 °C) von 20 bis 250 Pa·s aufweist.

10. Verwendung eines Verdrahtungssubstrats (100) nach einem der Ansprüche 1 bis 7 oder hergestellt durch ein Verfahren nach einem der Ansprüche 8 bis 9, in einem elektrischen Produkt wie etwa einem Computer, einem Mobiltelefon, einer Digitalkamera, einem Fernsehgerät, oder in einem Fahrzeug wie etwa einem Motorrad, einem Automobil, einem Zug, einem Schiff oder einem Flugzeug.

## Revendications

1. Substrat de câblage (100) ayant une fonction d'inducteur, le substrat de câblage (100) comprenant :
un substrat de couche interne (20) qui présente des première et seconde surfaces principales (20a, 20b) et une ouverture (21) formée pour pénétrer les première et seconde surfaces principales (20a, 20b) ;
une couche de matériau magnétique (22) qui est prévue à l'intérieur de l'ouverture (21) et présente un premier trou traversant (23) formé pour pénétrer les première et seconde surfaces principales de la couche de matériau magnétique (22) ;
un isolant (24) qui est prévu à l'intérieur du premier trou traversant (23) et présente un second trou traversant (25) formé pour pénétrer l'isolant (24) ;
un inducteur comprenant un premier motif conducteur (28) formé sur la première surface principale de la couche de matériau magnétique (22), un second motif conducteur (29) formé sur la seconde surface principale de la couche de matériau magnétique (22), et un conducteur de trou traversant (26) prévu à l'intérieur du second trou traversant (25) et connectant le premier motif conducteur (28) au second motif conducteur (29) ;
dans lequel le premier motif conducteur (28) est prévu directement en contact avec la première surface principale de la couche de matériau magnétique (22) ; **caractérisé en ce que**
le second motif conducteur (29) est prévu directement en contact avec la seconde surface principale de la couche de matériau magnétique (22).

2. Substrat de câblage (100) selon la revendication 1, dans lequel le substrat de couche interne (20) est un substrat isolant.

3. Substrat de câblage (100) selon l'une quelconque des revendications 1 à 2, dans lequel le substrat de couche interne (20) est un substrat de circuit.

4. Substrat de câblage (100) selon l'une quelconque des revendications précédentes, dans lequel le substrat de couche interne (20) présente une pluralité d'ouvertures, formées à des intervalles entre elles.

5. Substrat de câblage (100) selon l'une quelconque des revendications précédentes, dans lequel une pluralité des premiers trous traversants sont formés dans la couche de matériau magnétique (22).

6. Substrat de câblage (100) selon l'une quelconque des revendications précédentes, dans lequel l'isolant (24) présente une épaisseur qui est sensiblement la même qu'une épaisseur de la couche de matériau magnétique (22).

7. Substrat de câblage (100) selon l'une quelconque des revendications précédentes, dans lequel lorsqu'un diamètre du premier trou traversant est D1, un diamètre D2 du second trou traversant est de 0,8 D1 ou moins.

8. Procédé de production d'un substrat de câblage (100) présentant une fonction d'inducteur selon l'une quelconque des revendications précédentes, le procédé comprenant les étapes (A) à (G) suivantes consistant à :
(A) préparer un substrat de couche interne (20) qui présente des première et seconde surfaces principales (20a, 20b) et une ouverture (21) formée pour pénétrer les première et seconde surfaces principales (20a, 20b) ;
(B) remplir l'intérieur de l'ouverture avec une pâte de matériau magnétique et durcir thermiquement la pâte de matériau magnétique pour fournir une couche de matériau magnétique (22) ;
(C) former un premier trou traversant (23) pour pénétrer les première et seconde surfaces principales de la couche de matériau magnétique (22) ;
(D) fournir un isolant (24) à l'intérieur du premier trou traversant (23) ;
(E) former un second trou traversant (25) pour pénétrer l'isolant (24) ;
(F) former un conducteur de trou traversant (26) à l'intérieur du second trou traversant (25) ; et
(G) former des premier et second motifs conducteurs (28, 29) sur les première et seconde surfaces principales de la couche de matériau magnétique (22), respectivement, pour connecter les premier et second motifs conducteurs (28, 29) à un conducteur de trou traversant (26) en une forme de solénoïde.

9. Procédé selon la revendication 8, dans lequel la pâte de matériau magnétique présente une viscosité (25°C) de 20 à 250 Pa.s.

10. Utilisation d'un substrat de câblage (100) selon l'une quelconque des revendications 1 à 7, ou produit par un procédé selon l'une quelconque des revendications 8 à 9, dans un produit électrique tel qu'un ordinateur, un téléphone cellulaire, un appareil photo numérique, ou une télévision, ou dans un véhicule tel qu'une moto, une automobile, un train, un navire ou un aéronef.
